(19) Europäisches Patentamt
European Patent Office
Office européen des brevets

(11) EP 4 318 055 B1

(12) # EUROPEAN PATENT SPECIFICATION

(45) Date of publication and mention of the grant of the patent:
**14.01.2026 Bulletin 2026/03**

(21) Application number: **23187805.9**

(22) Date of filing: **26.07.2023**

(51) International Patent Classification (IPC):
***G02B 5/00*** $^{(2006.01)}$ ***G02B 5/20*** $^{(2006.01)}$
***G02B 5/28*** $^{(2006.01)}$ ***H10F 39/00*** $^{(2025.01)}$
***H10F 39/18*** $^{(2025.01)}$

(52) Cooperative Patent Classification (CPC):
**G02B 5/008; G02B 5/201; G02B 5/204; G02B 5/285; H10F 39/182; H10F 39/8053**

(54) **COLOR FILTER, IMAGE SENSOR, AND ELECTRONIC APPARATUS HAVING THE IMAGE SENSOR**

FARBFILTER, BILDSENSOR UND ELEKTRONISCHE VORRICHTUNG MIT DEM BILDSENSOR

FILTRE COLORÉ, CAPTEUR D'IMAGE ET APPAREIL ÉLECTRONIQUE COMPORTANT LE CAPTEUR D'IMAGE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **01.08.2022 KR 20220095691**

(43) Date of publication of application:
**07.02.2024 Bulletin 2024/06**

(73) Proprietor: **Samsung Electronics Co., Ltd.**
**Suwon-si, Gyeonggi-do 16677 (KR)**

(72) Inventors:
- **Chang, Hojun**
  **Suwon-si, Gyeonggi-do (KR)**
- **Kim, Hyochul**
  **Suwon-si, Gyeonggi-do (KR)**
- **Moon, Junhyuk**
  **Suwon-si, Gyeonggi-do (KR)**
- **Jung, Youngho**
  **Suwon-si, Gyeonggi-do (KR)**

(74) Representative: **Grünecker Patent- und Rechtsanwälte**
**PartG mbB**
**Leopoldstraße 4**
**80802 München (DE)**

(56) References cited:
**EP-A1- 3 993 044 US-A1- 2021 288 091**

- **DE PROFT ANABEL ET AL: "Highly Selective Color Filters Based on Hybrid Plasmonic-Dielectric Nanostructures", ACS PHOTONICS, vol. 9, no. 4, 31 March 2022 (2022-03-31), pages 1349 - 1357, XP093111276, ISSN: 2330-4022, DOI: 10.1021/acsphotonics.1c01983**
- **PETER B CATRYSSE ET AL: "Integrated color pixels in 0.18-?m complementary metal oxide semiconductor technology", JOURNAL OF THE OPTICAL SOCIETY OF AMERICA A,, vol. 20, no. 12, 1 December 2003 (2003-12-01), pages 2293 - 2306, XP002465440, ISSN: 1084-7529, DOI: 10.1364/JOSAA.20.002293**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 318 055 B1

## Description

BACKGROUND

### 1. Field

The disclosure relates to a color filter, an image sensor, and an electronic apparatus having the image sensor.

### 2. Description of the Related Art

In a display apparatus, a color filter is used not only for color expression, but also as a light-receiving device, such as a complementary metal oxide semiconductor (CMOS) image sensor. With the miniaturization of a display apparatus or a pixel of an image sensor, research has been conducted to reduce the thickness of a color filter.
De Proft et al. "Highly Selective Color Filters Based on Hybrid Plasmonic-Dielectric Nanostructures", ACS Photonics, vol. 9, no. 4, pages 1349-1357 (2022) discloses a transmission color filter design consisting of two parallel Al gratings with the same pitch embedded in a SiN slab at different heights.
Catrysse et al. "Integrated color pixels in a 0.18-μm complementary metal oxide semiconductor technology", Journal of the Optical Society of America A, vol. 20, no. 12, pages 2293-2306 (2003) relates to integrated color pixels in a standard CMOS technology and the transmittance of several one-dimensional and two-dimensional patterned metal layers.

SUMMARY

There is provided a color filter including an inorganic material.
There is provided an image sensor including an inorganic color filter.
There is provided an electronic apparatus including an inorganic color filter.
Additional aspects will be set forth in part in the description which follows and, in part, will be apparent from the description, or may be learned by practice of the presented embodiments.
According to an aspect of the disclosure, there is provided a color filter according to claim 1, including: a first dielectric layer; a second dielectric layer in on the first dielectric layer; and a metal array formed on the first dielectric layer and the second dielectric layer, the metal array comprising in which a plurality of metal elements are buried apart from each other in both of the first dielectric layer and the second dielectric layer, wherein each of the plurality of metal elements are in lateral contact with each of the first dielectric layer and the second dielectric layer, and wherein each of the plurality of metal elements are spaced apart from each other.
A first refractive index of the first dielectric layer is different from a second refractive index of the second dielectric layer.
A first ratio (d1/d) of a first thickness d1 of the first dielectric layer in lateral contact with each of the plurality of metal elements to a thickness d of the metal element may be in a range of about 0.1 to about 0.9, and a second ratio (d2/d) of a second thickness d2 of the second dielectric layer in lateral contact with each of the plurality of metal elements to the thickness d of the metal element may be in a range of about 0.1 to about 0.9.
In a first plasmonic resonance mode occurring between the first dielectric layer and each of the plurality of metal elements, the central wavelength of a transmission wavelength band of light may be tuned to a wavelength of any one of blue color, green color, or red color.
In a second plasmonic resonance mode occurring between the second dielectric layer and each of the plurality of metal elements, transmitted light may have a full width at half maximum of 50 nm or more.
The sum of thicknesses of the first dielectric layer and the second dielectric layer may be in a range of about 400 nm or less.
The arrangement period of the plurality of metal elements may be in a range of about 400 nm or less.
The color filter may further include a third dielectric layer, and each of the plurality of metal elements may be arranged in lateral contact with the third dielectric layer.
A plurality of pairs of the first dielectric layer and the second dielectric layer may be alternatingly stacked forming a distributed Bragg reflective layer.
The first dielectric layer may include one of $SiO_2$, SiN, $TiO_2$, $Al_2O_3$, or $HfO_2$.
The second dielectric layer may include one of $SiO_2$, SiN, $TiO_2$, $Al_2O_3$, or $HfO_2$.
Each of the plurality of metal elements may include at least one of Al, Au, Ag, W, Ti, Ni, or Cr.
Each of the plurality of metal elements may have one of a circular cross-section, a rectangular cross-section, a polygonal cross-section, an oval cross-section, a cross-shaped cross-section, or a ring-shaped cross-section.
A transmission wavelength bandwidth of incident light may be adjusted by adjusting at least one of thicknesses of each of the plurality of metal elements in lateral contact with the first dielectric layer and the second dielectric layer, an arrangement period of the plurality of metal elements, a maximum diameter of a cross-section of each of the plurality of metal elements, and a lateral surface inclination angle of each of the plurality of metal elements.

According to another aspect of the disclosure, there is provided an image sensor including according to claim 11, including: a photodetector comprising a plurality of photodetector cells for detecting light; and a color filter provided on the photodetector, wherein the color filter includes a color filter according to claim 1.

The photodetector may include a silicon-based photodiode.

The image sensor may further include a micro-lens array for focusing light on the color filter.

According to another aspect of the disclosure, there is provided a color filter including: a plurality of dielectric layers stacked in a first direction; and a plurality of metal elements provided in the plurality of dielectric layers, wherein each of the plurality of metal elements in at least two of the plurality of dielectric layers, and wherein each of the plurality of metal elements are spaced apart from each other in a second direction perpendicular to the first direction. In embodiments falling under the scope of claim 1, each of the plurality of metal elements are in lateral contact with at least a first dielectric layer and a second dielectric layer among the plurality of dielectric layers, wherein a first refractive index of the first dielectric layer is different from a second refractive index of the second dielectric layer.

## BRIEF DESCRIPTION OF THE DRAWINGS

These and/or other aspects will become apparent and more readily appreciated from the following description of the embodiments, taken in conjunction with the accompanying drawings in which:

FIG. 1 is a cross-sectional view of a color filter according to an example embodiment;
FIG. 2 is a plan view of a color filter according to an example embodiment;
FIG. 3 is a plan view of a color filter according to an example embodiment;
FIG. 4 illustrates a modified example of a burial position of a metal element in a color filter according to an example embodiment;
FIG. 5A illustrates a structure in which an Al element is in lateral contact with an $SiO_2$ layer only in a color filter according to a comparative example;
FIG. 5B illustrates a structure in which an Al element is in lateral contact with an SiN layer and an $SiO_2$ layer in a 1:1 thickness ratio in a color filter according to an example embodiment;
FIG. 5C illustrates a structure in which an Al element is in lateral contact with an SiN layer only in a color filter according to a comparative example;
FIG. 6 is a graph showing a transmittance according to a wavelength, when each of the color filters illustrated in FIGS. 5A, 5B, and 5C is configured to transmit blue light;
FIG. 7 is a graph showing a transmittance according to a wavelength, when each of the color filters illustrated in FIGS. 5A, 5B, and 5C is configured to transmit green light;
FIG. 8 is a graph showing a transmittance according to a wavelength, when each of the color filters illustrated in FIGS. 5A, 5B, and 5C is configured to transmit red light;
FIG. 9A is a schematic perspective view of an image sensor according to an example embodiment;
FIG. 9B is a schematic plan view showing the structure of a photodetector employed in an image sensor according to an example embodiment;
FIG. 10 illustrates an example in which a micro-lens array is further included in the image sensor of FIG. 9A;
FIG. 11 is a graph showing a transmittance according to a wavelength in a blue pixel, a green pixel, and a red pixel of a color filter according to an example embodiment;
FIG. 12 is a graph showing a transmittance according to a wavelength in a blue pixel, a green pixel, and a red pixel of an image sensor according to an example embodiment;
FIG. 13 illustrates an example in which a color filter according to an example embodiment includes three dielectric layers;
FIG. 14 illustrates an example in which a color filter according to an example embodiment includes a distributed Bragg reflective layer;
FIGS. 15A to 15F illustrate examples of various shapes of a metal element employed in a color filter according to an example embodiment;
FIG. 16 schematically illustrates an optical interconnector applied with a color filter according to an example embodiment;
FIG. 17 schematically illustrates a display apparatus including a color filter according to an example embodiment;
FIG. 18 is a schematic block diagram of an electronic apparatus including an image sensor according to some example embodiments;
FIG. 19 is a schematic block diagram of a camera module of FIG. 18; and
FIGS. 20A, 20B, 20C, 20D, 20E, 21A, 21B, 21C, 21D, and 21E illustrate various examples of an electronic apparatus including an image sensor according to some example embodiments.

DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects.

Hereinafter, a color filter, an image sensor, and an electronic apparatus having the same, according to various embodiments will be described in detail by explaining embodiments of the disclosure with reference to the attached drawings. Throughout the drawings, like reference numerals denote like elements, and sizes of components in the drawings may be exaggerated for convenience of explanation and clarity. While such terms as "first," "second," etc., may be used to describe various components, such components must not be limited to the above terms. The above terms are used only to distinguish one component from another.

The expression of singularity in the specification includes the expression of plurality unless clearly specified otherwise in context. It will be further understood that the terms "comprises" and/or "comprising" used herein specify the presence of stated features or components, but do not preclude the presence or addition of one or more other features or components. Furthermore, sizes of components in the drawings may be exaggerated for convenience of explanation. Furthermore, when a certain material layer is described to exist on a substrate or another layer, the material layer may exist directly on the substrate or the other layer or a third layer may be interposed therebetween. In an example embodiment below, as a material forming each layer is exemplary, other different materials may be used.

Furthermore, a "module" or "portion" may perform at least one of functions or operations, and may be implemented by hardware or software or a combination of hardware and software.

The particular implementations shown and described herein are illustrative examples of the disclosure and are not intended to otherwise limit the scope of the disclosure in any way. For the sake of brevity, conventional electronics, control systems, software development and other functional aspects of the systems (and components of the individual operating components of the systems) may not be described in detail. Furthermore, the connecting lines, or connectors shown in the various figures presented are intended to represent functional relationships and/or physical or logical couplings between the various elements.

The use of terms "a" and "an" and "the" and similar referents in the context of describing the disclosure (especially in the context of the following claims) are to be construed to cover both the singular and the plural.

The steps of all methods described herein can be performed in any suitable order unless otherwise indicated herein or otherwise clearly contradicted by context. Furthermore, the use of any and all examples, or language (e.g., "such as") provided herein, is intended merely to better illuminate the disclosure and does not pose a limitation on the scope of the disclosure unless otherwise claimed.

FIG. 1 is a cross-sectional view of a color filter 100 according to an example embodiment, and FIG. 2 is a plan view of the color filter 100 of FIG. 1.

The color filter 100 includes a first dielectric layer 110, a second dielectric layer 120 on the first dielectric layer 110, and a metal array 130 provided on the first dielectric layer 110 and the second dielectric layer 120. The metal array 130 is formed by a plurality of metal elements 131 buried in both of the first dielectric layer 110 and the second dielectric layer 120 are arranged spaced apart from each other.

Each of the metal elements 131 is buried in a stack direction (Y direction) of the first dielectric layer 110 and the second dielectric layer 120, and each of the metal elements 131 is in lateral contact with both of the first dielectric layer 110 and the second dielectric layer 120. Each of the metal elements 131 may include an upper surface 1311, a lower surface 1312 facing the upper surface 1311, and a lateral surface 1313 between the upper surface 1311 and the lower surface 1312. In other words, the lateral surface 1313 may denote a surface connecting the upper surface 1311 with the lower surface 1312. According to an example embodiment, the lateral surface 1313 may be referred to as a side surface. The upper surface 1311 and the lower surface 1312 may be surfaces perpendicular to the stack direction (Y direction), and the lateral surface 1313 may be a surface parallel to the stack direction (Y direction). The lateral contact may mean that each of the metal elements 131 is in contact with the first dielectric layer 110 and the second dielectric layer 120 in the stack direction (Y direction). The stack direction (Y direction) may be the same direction in which incident light L propagates. A direction perpendicular to the stack direction (Y direction) is referred to as a first horizontal direction (X direction), and a direction perpendicular to the stack direction (Y direction) and the first horizontal direction (X direction) is referred to as a second horizontal direction (Z direction).

Referring to FIG. 2, the metal elements 131 are arranged spaced apart from each other in the first horizontal direction (X direction). The metal elements 131 are periodically arranged, and when an arrangement period of the metal elements 131 in the X direction is P, an arrangement period P may be in a range of about 400 nm or less. The arrangement period P may be in a range of about 10 nm to about 400 nm. A diameter D of each of the metal elements 131 may be 400 nm or less. The diameter D of each of the metal elements 131 may be in a range of about 10 nm to about 400 nm. The peak wavelength of transmitted light may be adjusted by adjusting the arrangement period P and the diameter D of each of the metal elements 131.

The metal elements 131 may be regularly arranged by various methods. For example, the metal elements 131 may be arranged in the same arrangement period P with respect to the X direction and the Z direction.

Alternatively, as illustrated in FIG. 3, the metal elements 131 may be arranged in the same arrangement period P with respect to the X direction and diagonal directions to the X direction and the Z direction. However, the arrangement method of the metal elements 131 is not limited thereto, and the metal elements 131 may be arranged by various methods.

The first dielectric layer 110 may include one of $SiO_2$, SiN, $TiO_2$, $Al_2O_3$, and HfO. The second dielectric layer 120 may include one of $SiO_2$, SiN, $TiO_2$, $Al_2O_3$, and HfO. The refractive index of the first dielectric layer 110 is different from the refractive index of the second dielectric layer 120. The thickness of the first dielectric layer 110 may be greater than or the same as the thickness of the second dielectric layer 120. The sum of the thicknesses of the first dielectric layer 110 and the second dielectric layer 120 may be in a range of about 400 nm or less. The sum of the thicknesses of the first dielectric layer 110 and the second dielectric layer 120 may be in a range of about 10 nm to about 400 nm. The thickness of the color filter 100 may be reduced by decreasing the thicknesses of the first dielectric layer 110 and the second dielectric layer 120, and thus, the color filter 100 may be applied to a miniaturized image sensor.

According to an example embodiment, the upper surface 1311 of each of the metal elements 131 may be arranged to be exposed from the second dielectric layer 120 as illustrated in FIG. 1. That is, according to an example embodiment, the dielectric layer 120 is not provided over the upper surface 1311. However, the disclosure is not limited thereto, and as illustrated in FIG. 4, each of the metal elements 131 may be completely buried so as not to be exposed from the first dielectric layer 110 and the second dielectric layer 120.

Referring back to FIG. 1, a ratio (d1/d) of a first thickness d1 of the first dielectric layer 110 in lateral contact with each of the metal elements 131 to a thickness d of each of the metal elements 131 may be in a range of about 0.1 to about 0.9. Furthermore, a ratio (d2/d) of a second thickness d2 of the second dielectric layer 120 in lateral contact with each of the metal elements 131 to a thickness d of each of the metal elements 131 may be in a range of about 0.1 to about 0.9. By adjusting the first thickness d1 and the second thickness d2, the full width at half maximum of a transmission wavelength band of the incident light L may be adjusted. In addition, the transmission wavelength bandwidth of the incident light L may be adjusted by adjusting at least one of the arrangement period P of the metal elements 131, the maximum diameter D of a cross-section of each of the metal elements 131, and a lateral surface inclination angle of each of the metal elements 131.

As each of the metal elements 131 is in lateral contact with both of the first dielectric layer 110 and the second dielectric layer 120 together, red, green, and blue wavelength bandwidths suitable for the color filter 100, or the full width at half maximum, may be secured.

FIG. 5A illustrates a comparative example having a structure in which an $SiO_2$ layer is stacked on an SiN layer, and an Al element is not in lateral contact with the SiN layer and is in lateral contact with the $SiO_2$ layer only (0% in SiN). FIG. 5B illustrates a color filter according to an example embodiment, in which a thickness d1 of an Al element in lateral contact with an SiN layer and a thickness d2 of the Al element in lateral contact with an $SiO_2$ layer have a ratio of 1:1 (50% in SiN). FIG. 5C illustrate another comparative example having a structure in which an Al element is in lateral contact with an SiN layer only and is not in lateral contact with an $SiO_2$ layer (100% in SiN).

FIG. 6 is graph showing a transmittance according to the wavelength of light in a structure in which a color filter is configured to transmit blue wavelength light, FIG. 7 is graph showing a transmittance according to the wavelength of light in a structure in which a color filter is configured to transmit green wavelength light and FIG. 8 is graph showing a transmittance according to the wavelength of light in a structure in which a color filter is configured to transmit red wavelength light. In FIGS. 6, 7 and 8, line a indicates transmittances according to the wavelength of light with respect to the structure of FIG. 5A, line b indicates transmittances according to the wavelength of light with respect to the structure of FIG. 5B, and line c indicates transmittances according to the wavelength of light with respect to the structure of FIG. 5C. Referring to FIG. 6, the lines a and b indicate that a transmittance of 40% or more is secured, but the full width at half maximum of a blue wavelength band of the line a is relatively less than the full width at half maximum of a blue wavelength band of the line b. The line b shows that the full width at half maximum of transmitted light is about 50 nm or more. The line c shows that light transmittance is relatively small so that it is difficult to operate as a color filter. The color filter according to an example embodiment may have a full width at half maximum in a range of about 50 nm to about 150 nm with respect to blue wavelength light.

Referring to FIG. 7, the lines line a and b indicate that a transmittance of 40% or more is secured, but the full width at half maximum of a green wavelength band of the line a is relatively less than the full width at half maximum of a green wavelength band of the line b. The full width at half maximum of a green wavelength band of the line b may be 50 nm or more. The color filter according to an example embodiment may have the full width at half maximum in a range of about 50 nm to about 150 nm with respect to the green wavelength light. The line c shows that light transmittance is relatively small so that it is difficult to operate as a color filter.

Referring to FIG. 8, all lines a, b, and c indicate that a transmittance of 40% or more is secured, and the full width at half maximum of a red wavelength band of the lines a, b, and c may be 50 nm or more.

FIG. 9A is a schematic perspective view of an image sensor 200 according to an example embodiment, and FIG. 9B is a schematic plan view showing the structure of a photodetector 210 employed in the image sensor 200 of FIG. 9A.

The image sensor 200 may include the photodetector 210 including a plurality of photodetector cells for detecting light and the color filter 100 on the photodetector 210. FIG. 9A illustrates a structure corresponding to one pixel, for convenience of explanation.

The photodetector 210 may include a first photodetector cell 211, a second photodetector cell 212, a third photodetector cell 213, and a fourth photodetector cell 214, which convert light into an electrical signal. The photodetector 210 may be a silicon-based photodiode.

Referring to FIGS. 9A and 9B, the first photodetector cell 211, the second photodetector cell 212, the third photodetector cell 213, the fourth photodetector cell 214 may be arranged in a 2×2 arrangement structure. Such an area division is to sense incident light in units of sub-pixel units, for example, the first photodetector cell 211 may sense light of a first wavelength corresponding to a first sub-pixel SUB1, the second photodetector cell 212 may sense light of a second wavelength corresponding to a second sub-pixel SUB2, the third photodetector cell 213 may sense light of a third wavelength corresponding to a third sub-pixel SUB3, and the fourth photodetector cell 214 may sense light of a fourth wavelength corresponding to a fourth sub-pixel SUB4. The first sub-pixel SUB1, the second sub-pixel SUB2, the third sub-pixel SUB3, and the fourth sub-pixel SUB4 may be a blue sub-pixel, a green sub-pixel, a red sub-pixel, and a green sub-pixel, respectively, but the disclosure is not limited thereto. Although not illustrated, a separation film may be further provided in a boundary between sub-pixels.

As the color filter 100 is substantially the same as those described with reference to FIGS. 1 to 4, a detailed description thereof is omitted. For the color filter 100 to transmit color light corresponding to each of the first sub-pixel SUB1, the second sub-pixel SUB2, the third sub-pixel SUB3, and the fourth sub-pixel SUB4, the diameter D of each of the metal elements 131, the arrangement period P of the metal elements 131, the material of the first dielectric layer 110, the material of the second dielectric layer 120, the material of each of the metal elements 131, and the like may be adjusted.

For example, assuming that the diameter of each of the metal elements 131 of the first sub-pixel SUB1 is D1, the diameter of each of the metal elements 131 of the second sub-pixel SUB2 and the fourth sub-pixel SUB4 is D2, and the diameter of each of the metal elements 131 of the third sub-pixel SUB3 is D3, a relation that $D1<D2<D3$ may be established.

FIG. 10 illustrates an example in which a micro-lens array is further provided in the image sensor 200 of FIG. 9.

A micro-lens array 230 may be provided on the color filter 100. The micro-lens array 230 may include a micro-lens 231 arranged to correspond to each sub-pixel. The micro-lens 231 may focus light on a sub-pixel corresponding to the incident light.

FIG. 11 is a graph showing a transmittance according to the wavelength of a color filter according to an example embodiment. In FIG. 11, B indicates a transmittance with respect to a blue color filter, G indicates a transmittance with respect to a green color filter, and R indicates a transmittance with respect to a red color filter. FIG. 11 is a graph showing that the full width at half maximum of a wavelength band and a transmittance of a corresponding color in each color filter are secured.

FIG. 12 is a graph showing a transmittance according to the wavelength of the image sensor of FIG. 10. Compared with FIG. 11, the full width at half maximum of a wavelength band of each color may be secured relatively much.

Next, the operation of a color filter according to an example embodiment is described. The color filter according to an example embodiment may have a thickness of 400 nm or less to be applicable to a micro-pixel, by using plasmonic resonance. Referring to FIG. 1, in a structure in which the dielectric layers 110 and 120 are stacked, the metal elements 131 are arranged to simultaneously be in lateral contact with the dielectric layers 110 and 120, and thus, a plasmonic resonance wavelength is formed from the lateral contact between each of the metal elements 131 and the dielectric layers 110 and 120, thereby the bandwidth of transmitted light may be adjusted.

A first plasmonic resonance mode occurring between the first dielectric layer 110 and each of the metal elements 131 may be configured such that the central wavelength of a transmission wavelength band of light is tuned to the wavelength of any one of blue, green, and red. The bandwidth or full width at half maximum of transmitted light may be adjusted by using a second plasmonic resonance mode occurring between the second dielectric layer 120 and each of the metal elements 131. The second plasmonic resonance mode may be configured such that the transmitted light has a full width at half maximum of 50 nm or more. The second plasmonic resonance mode may be configured such that the transmitted light has a full width at half maximum in a range of about 50 nm to about 150 nm.

The relation between the period of a two-dimensional plasmonic grating structure in which the metal elements 131 are arranged two-dimensionally and the wavelength of transmitted light is described below with reference to FIG. 2. A wavelength $\lambda max$ at which a transmittance becomes maximum with respect to a permittivity $\varepsilon$ of a dielectric layer and the arrangement period P of each of the metal elements 131 is as follows.

$$\lambda_{max} = \frac{P}{\sqrt{(i^2+j^2)}}\sqrt{\frac{\varepsilon_m \varepsilon_d}{\varepsilon_m + \varepsilon_d}}$$

<Equation 1>

In Equation 1, $\varepsilon_m$ denotes the permittivity of a metal element, and $\varepsilon_d$ denotes the permittivity of a dielectric layer. i and j denote scattering orders, and referring to FIG. 2, it may be that (i,j)=(1,0) and (i,j)=(0,1).

By using Equation 1, when there is a desired maximum wavelength λmax, the arrangement period P of metal elements may be inversely calculated by using the permittivities of a dielectric layer and the metal element. The plasmonic resonance mode is tuned to fit to the central wavelengths of red, green, and blue, and a structure to make the arrangement period of metal elements as short as possible may be found.

The relation of the period and the wavelength of a two-dimensional plasmonic grating structure in which metal elements are arranged two-dimensionally is described below with reference to FIG. 3. The wavelength λmax at which the transmittance becomes maximum with respect to the permittivity ε of a dielectric layer and the arrangement period P of metal elements is as follows.

$$\lambda_{max} = \frac{P}{\sqrt{\frac{4}{3}(i^2+ij+j^2)}}\sqrt{\frac{\varepsilon_m \varepsilon_d}{\varepsilon_m + \varepsilon_d}}$$

<Equation 2>

By using Equation 2, when there is a desired maximum wavelength λmax, the arrangement period P of metal elements may be inversely calculated by using the permittivities of a dielectric layer and the metal elements. Here, it may be that (i,j)=(1,0), (i,j)=(0,1), and (i,j)=(1, 1).

The central wavelength band may be set in a wavelength band in which the plasmonic resonance mode of first dielectric layer 110 and each of the metal elements 131 and the plasmonic resonance mode of the second dielectric layer 120 and each of the metal elements 131. For example, the central wavelength may be set such that a plasmonic resonance mode by Al-SiN and a plasmonic resonance mode by Al-$SiO_2$ overlap each other with respect to the relation that (i, j) = (0, 1). The color filter according to an example embodiment has a structure in which metal elements are inserted in a multi-dielectric layer, for example, in a process of transmitting light to a photodetector of an image sensor, R, G, and B color transmission characteristics may be obtained by combining the first plasmonic resonance mode between each of the metal elements 131 and the first dielectric layer 110 and the second plasmonic resonance mode between each of the metal elements 131 and the second dielectric layer 120. The first plasmonic resonance mode may be reinforced by the lateral contact between each of the metal elements 131 and the first dielectric layer 110, and the second plasmonic resonance mode may be reinforced by the lateral contact between each of the metal elements 131 and the second dielectric layer 120. The two-dimensional grating structure of the metal elements 131 may form an R, G, and B band-pass filter.

In the color filter according to an example embodiment, an aspect ratio of a color filter compared with a pixel may be 1 or less based on a 400 nm micro-pixel. In other words, in a 400 nm pixel, while maintaining the thickness of a color filter to be as thin as 400 nm or less, a band-pass transmission spectrum of R, G, and B bands may be obtained. In the color filter according to an example embodiment, in addition to the adjusting the period of the two-dimensional grating of metal elements and the diameter of each metal element, by adjusting the thickness of a lateral contact between the metal element and the first dielectric layer and the thickness of a lateral contact between the metal element and the second dielectric layer, the central wavelength of a transmission wavelength band and the transmission wavelength bandwidth may be tuned.

FIG. 13 illustrates an example in which a third dielectric layer 125 is further provided in the color filter 100 of FIG. 1. A color filter 100A may include the first dielectric layer 110, the second dielectric layer 120 on the first dielectric layer 110, and a third dielectric layer 125 on the second dielectric layer 120, and each of the metal elements 131 may be buried in lateral contact with all of the first dielectric layer 110, the second dielectric layer 120, and the third dielectric layer 125. The first dielectric layer 110, the second dielectric layer 120, and the third dielectric layer 125 are sequentially stacked, and the first dielectric layer 110, the second dielectric layer 120, and the third dielectric layer 125 may have different refractive indexes. Alternatively, the first dielectric layer 110 and the third dielectric layer 125 may have the same refractive index, and the second dielectric layer 120 may have a refractive index different from that of the first dielectric layer 110. The third dielectric layer 125 may include one of $SiO_2$, SiN, $TiO_2$, $Al_2O_3$, and HfO.

FIG. 14 illustrates an example in which the first dielectric layer 110 and the second dielectric layer 120 in the color filter 100 of FIG. 1 are provided as a distributed Bragg reflective layer.

A color filter 100B may include a distributed Bragg reflective layer 140 including a plurality of pairs of the first dielectric layer 110 and the second dielectric layer 120 that are alternately stacked, and each of the metal elements 131 may be buried in lateral contact with the distributed Bragg reflective layer 140. When the distributed Bragg reflective layer 140 is used, the overlapping of plasmonic resonance modes by multiple pairs of the first dielectric layer 110 and the second dielectric layer 120 may be used. For example, when two pairs of Al-$SiO_2$/Al-SiN are provided, an effect such as a transmittance spectrum in which a plasmonic resonance mode by Al-$SiO_2$/AL-SiN is first mixed is passed one more time through the same structure.

Next, FIGS. 15A to 15F are plan view showing example shapes of a metal element employed in a color filter according to an example embodiment.

As illustrated in FIG. 15A, each of the metal elements 131 may have a circular cross-section. As illustrated in FIG. 15B, each of the metal elements 131 may have an oval cross-section. As illustrated in FIG. 15C, each of the metal elements 131 may have a rectangle cross-section. As illustrated in FIG. 15D, each of the metal elements 131 may have a hexagonal cross-section. In addition, each of the metal elements 131 may have various polygonal cross-sections. As illustrated in FIG. 15E, each of the metal elements 131 may have a cross-shaped cross-section. As illustrated in FIG. 15F, each of the metal elements 131 may have a ring-shaped cross-section.

The diameter D of each of the metal elements 131 illustrated in FIGS. 15A to 15F denotes the maximum diameter of each cross-sectional shape.

FIG. 16 illustrates an example that a color filter according to an example embodiment is applied to an optical interconnector 300.

The optical interconnector 300 may include a first waveguide 310, a second waveguide 320 arranged to face the first waveguide 310, and the color filter 100 between the first waveguide 310 and the second waveguide 320. As the color filter 100 is substantially the same as that described with reference to FIGS. 1 to 4, a detailed description thereof is omitted. The first waveguide 310 and the second waveguide 320 may each include silicon.

An input coupler 341 to allow light transmitted via the first waveguide 310 to be incident on the second dielectric layer 120 may be provided in the second dielectric layer 120. The input coupler 341 has a grating structure, and may be in contact with the first waveguide 310.

An insertion layer 325 may be further provided between the second waveguide 320 and the first dielectric layer 110. An output coupler 342 to allow light passing through the first dielectric layer 110 to be output to the second waveguide 320 may be provided in the insertion layer 325. The output coupler 342 has a grating structure, and may be in contact with the second waveguide 320.

The color filter 100 may be used as a vertical direction optical filter of the optical interconnector 300. The optical interconnector 300 allows light to travel in an in-plane direction, and to increase a degree of integration of the optical interconnector 300, light of a specific wavelength band may travel in a vertical direction. The vertical direction may indicate a direction from the first waveguide 310 to the second waveguide 320. The light travelling via the first waveguide 310 is transmitted as light of the specific wavelength band through the color filter 100 and may be output via the second waveguide 320. When the color filter 100 according to an example embodiment is applied to the optical interconnector 300, the color filter 100 may operate as a narrow band-pass filter or a notch filter.

FIG. 17 illustrates an example in which the color filter 100 of FIG. 1 is applied to a display apparatus 400.

The display apparatus 400 may include a light source 410, a display panel 420 for displaying an image by using light output from the light source 410, and the color filter 100 on the display panel 420. As the color filter 100 is substantially the same as that described with reference to FIGS. 1 to 4, a detailed description thereof is omitted.

The color filter 100 may further include a cover glass 430. A first antireflective coating layer 431 may be provided between the color filter 100 and the cover glass 430, and a second antireflective coating layer 432 may be provided on the cover glass 430.

For a color filter used in a CMOS image sensor, light passes through a micro-lens and a color filter and then arrives at a photodetector. Conversely, for a display apparatus, light from the light source 410 and the display panel 420 transmits an image to air through the color filter 100 without a micro-lens, and thus, optimal tuning of the color filter 100 may be designed to fit to optical elements of the display apparatus, not to the photodetector. Furthermore, to more increase transmittance, the material of each of the metal elements 131 or the thickness of each of the metal elements 131 may be adjusted.

The color filter according to an example embodiment is implemented in the form of a chip corresponding to a photodetector, such as a silicon photodiode so as to be mounted as a component of a camera module of a mobile phone. Furthermore, the color filter may be applied to cameras for vehicles, auxiliary cameras of various display apparatuses, such as TVs, virtual reality (VR) devices, augmented reality (AR) devices, and the like.

FIG. 18 is a schematic block diagram showing an example of an electronic apparatus ED01 including an image sensor. Referring to FIG. 18, in a network environment ED00, the electronic apparatus ED01 may communicate with another electronic apparatus ED02 through a first network ED98 (a short-range wireless communication network and the like), or another electronic apparatus ED04 and/or a server ED08 through a second network ED99 (a long-range wireless communication network and the like). The electronic apparatus ED01 may communicate with the electronic apparatus ED04 through the server ED08. The electronic apparatus ED01 may include a processor ED20, a memory ED30, an input device ED50, an audio output device ED55, a display apparatus ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some of the constituent elements (the display apparatus ED60 and the like) may be omitted or another constituent element may be added. Some of these constituent elements may be implemented as one integrated circuit. For example, the sensor module ED76 (a fingerprint sensor, an iris sensor, an illuminance sensor, and the like) may be implemented by being embedded in the display apparatus ED60 (a display and the like). Furthermore, when the image sensor 200 include a spectrum function, some functions (a color sensor and an illuminance sensor) of the sensor module may be realized in the image sensor 200, not in a separate sensor module.

The processor ED20 may control, by executing software (a program ED40 and the like), one or a plurality of other constituent elements (a hardware or software constituent element and the like) of the electronic apparatus ED01 connected to the processor ED20, and perform various data processing or operations. As part of data processing or operations, the processor ED20 may load commands and/or data received from other constituent elements (the sensor module ED76, the communication module ED90, and the like) in a volatile memory ED32, process the command and/or data stored in the volatile memory ED32, and store resultant data in a non-volatile memory ED34. The processor ED20 may include a main processor ED21 (a central processing unit, an application processor, and the like) and an auxiliary processor ED23 (a graphics processing unit, an image signal processor, a sensor hub processor, a communication processor, and the like), which are operable independently or together. The auxiliary processor ED23 may consume less power than the main processor ED21 and may perform a specialized function.

The auxiliary processor ED23 may control functions and/or states related to some constituent elements (the display apparatus ED60, the sensor module ED76, the communication module ED90, and the like) of the electronic apparatus ED01, instead of the main processor ED21 when the main processor ED21 is in an inactive state (a sleep state), or with the main processor ED21 when the main processor ED21 is in an active state (an application execution state). The auxiliary processor ED23 (an image signal processor, a communication processor, and the like) may be implemented as a part of functionally related other constituent elements (the camera module ED80, the communication module ED90, and the like).

The memory ED30 may store various pieces of data needed for constituent element (the processor ED20, the sensor module ED76, and the like) of the electronic apparatus ED01. The data may include, for example, software (the program ED40 and the like) and input data and/or output data regarding commands related thereto. The memory ED30 may include the volatile memory ED32 and/or the non-volatile memory ED34. The non-volatile memory ED32 may include a built-in memory ED36 fixedly installed in the electronic apparatus ED01 and an external memory ED38 that is detachable.

The program ED40 may be stored as software in the memory ED30, and may include an operating system ED42, a middleware ED44, and/or an application ED46.

The input device ED50 may receive commands and/or data to be used in the constituent elements (the processor ED20 and the like) of the electronic apparatus ED01, from the outside (a user and the like) of the electronic apparatus ED01. The input device ED50 may include a microphone, a mouse, a keyboard, and/or a digital pen (a stylus pen and the like).

The audio output device ED55 may output an audio signal to the outside of the electronic apparatus ED01. The audio output device ED55 may include a speaker and/or a receiver. The speaker may be used for general purposes such as multimedia playback or recording playback, and the receiver may be used to receive incoming calls. The receiver may be combined as a part of the speaker or implemented as an independent separate device.

The display apparatus ED60 may visually provide information to the outside of the electronic apparatus ED01. The display apparatus ED60 may include a display, a hologram device, or a projector, and a control circuit for controlling such a device. The display apparatus ED60 may include a touch circuitry set to sense a touch, and/or a sensor circuit (a pressure sensor and the like) set to measure the strength of a force generated by the touch.

The audio module ED70 may convert sound into an electrical signal or reversely an electrical signal into sound. The audio module ED70 may obtain sound through the input device ED50, or output sound through the audio output device ED55 and/or a speaker and/or a headphone of another electronic apparatus (the electronic apparatus ED02 and the like) connected to the electronic apparatus ED01 in a wired or wireless manner.

The sensor module ED76 may sense an operation state (power, a temperature, and the like) of the electronic apparatus ED01, or an external environment state (a user state and the like), and generate an electrical signal and/or data value corresponding to a sensed state. The sensor module ED76 may include a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface ED77 may support one or more designated protocols to be used for connecting the electronic apparatus ED01 to another electronic apparatus (the electronic apparatus ED02 and the like) in a wired or wireless manner. The interface ED77 may include a high definition multimedia interface (HDMI), a universal serial bus (USB) interface, an SD card interface, and/or an audio interface.

A connection terminal ED78 may include a connector for physically connecting the electronic apparatus ED01 to another electronic apparatus (the electronic apparatus ED02 and the like). The connection terminal ED78 may include an HDMI connector, a USB connector, an SD card connector, and/or an audio connector (a headphone connector and the like).

The haptic module ED79 may convert electrical signals into mechanical stimuli (vibrations, movements, and the like) or electrical stimuli that are perceivable by a user through tactile or motor sensations. The haptic module ED79 may include a motor, a piezoelectric device, and/or an electrical stimulation device.

The camera module ED80 may capture a still image and a video. The camera module ED80 may include a lens assembly including one or a plurality of lenses, the image sensor 200 of FIG. 9A, image signal processors, and/or flashes. The lens assembly included in the camera module ED80 may collect light emitted from an object that is a target for image capturing.

The power management module ED88 may manage power supplied to the electronic apparatus ED01. The power management module ED88 may be implemented as a part of a power management integrated circuit (PMIC).

The battery ED89 may supply power to the constituent elements of the electronic apparatus ED01. The battery ED89 may include non-rechargeable primary cells, rechargeable secondary cells, and/or fuel cells.

The communication module ED90 may establish a wired communication channel and/or a wireless communication channel between the electronic apparatus ED01 and another electronic apparatus (the electronic apparatus ED02, the electronic apparatus ED04, the server ED08, and the like), and support a communication through an established communication channel. The communication module ED90 may be operated independently of the processor ED20 (the application processor and the like), and may include one or a plurality of communication processors supporting a wired communication and/or a wireless communication. The communication module ED90 may include a wireless communication module ED92 (a cellular communication module, a short-range wireless communication module, a global navigation satellite system (GNSS) communication module, and the like), and/or a wired communication module ED94 (a local area network (LAN) communication module, a power line communication module, and the like). Among the above communication modules, a corresponding communication module may communicate with another electronic apparatus through the first network ED98 (a short-range communication network such as Bluetooth, WiFi Direct, or infrared data association (IrDA)) or the second network ED99 (a long-range communication network such as a cellular network, the Internet, or a computer network (LAN, WAN, and the like)). These various types of communication modules may be integrated into one constituent element (a single chip and the like), or may be implemented as a plurality of separate constituent elements (multiple chips). The wireless communication module ED92 may verify and authenticate the electronic apparatus ED01 in a communication network such as the first network ED98 and/or the second network ED99 by using subscriber information (an international mobile subscriber identifier (IMSI) and the like) stored in the subscriber identification module ED96.

The antenna module ED97 may transmit signals and/or power to the outside (another electronic apparatus and the like) or receive signals and/or power from the outside. An antenna may include an emitter formed in a conductive pattern on a substrate (a printed circuit board (PCB) and the like). The antenna module ED97 may include one or a plurality of antennas. When the antenna module ED97 includes a plurality of antennas, the communication module ED90 may select, from among the antennas, an appropriate antenna for a communication method used in a communication network such as the first network ED98 and/or the second network ED99. Signals and/or power may be transmitted or received between the communication module ED90 and another electronic apparatus through the selected antenna. Other parts (an RFIC and the like) than the antenna may be included as a part of the antenna module ED97.

Some of the constituent elements may be connected to each other through a communication method between peripheral devices (a bus, general purpose input and output (GPIO), a serial peripheral interface (SPI), a mobile industry processor interface (MIPI), and the like) and may mutually exchange signals (commands, data, and the like).

The command or data may be transmitted or received between the electronic apparatus ED01 and the external electronic apparatus ED04 through the server ED08 connected to the second network ED99. The electronic apparatuses ED02 and ED04 may be of a type that is the same as or different from the electronic apparatus ED01. All or a part of operations executed in the electronic apparatus ED01 may be executed in one or a plurality of the electronic apparatuses (ED02, ED04, and ED08). For example, when the electronic apparatus ED01 needs to perform a function or service, the electronic apparatus ED01 may request one or a plurality of electronic apparatuses to perform part of the whole of the function or service, instead of performing the function or service. The one or a plurality of the electronic apparatuses receiving the request may perform additional function or service related to the request, and transmit a result of the performance to the electronic apparatus ED01. To this end, cloud computing, distributed computing, and/or client-server computing technology may be used.

FIG. 19 is a block diagram showing an example of the camera module ED80 of FIG. 18. Referring to FIG. 19, the camera module ED80 may include a lens assembly CM10, a flash CM20, the image sensor 200 (the image sensor 200 of FIG. 9A and the like), an image stabilizer CM40, a memory CM50 (a buffer memory and the like), and/or an image signal processor CM60. The lens assembly CM10 may collect light emitted from an object that is a target for image capturing. The camera module ED80 may include a plurality of lens assemblies CM10, and in this case, the camera module ED80 may be a dual camera, a 360-degree camera, or a spherical camera. Sone of the lens assemblies CM10 may have the same or different lens attributes (a viewing angle, a focal length, autofocus, F number, optical zoom, and the like). The lens assembly CM10 may include a wide-angle lens or a telephoto lens.

The flash CM20 may emit light used to reinforce light emitted or reflected from the object. The flash CM20 may include one or a plurality of light-emitting diodes (LEDs) (a red-green-blue (RGB) LED, a white LED, an infrared LED, an ultraviolet LED, and the like), and/or a xenon lamp. The image sensor 200 may be the image sensor described with reference to FIG. 9A or 10, and may convert light emitted or reflected from the object and transmitted through the lens assembly CM10 into electrical signals, thereby obtaining an image corresponding to the object. The image sensor 200 may include one or a plurality of sensors selected from image sensors having different attributes, such as an RGB sensor, a black and white (BW) sensor, an IR sensor, or UV sensor. Each sensor included in the image sensor 200 may be implemented by a charged coupled device (CCD) sensor and/or a complementary metal oxide semiconductor (CMOS) sensor.

The image stabilizer CM40 may move, in response to a movement of the camera module CM80, one or a plurality of lenses included in the lens assembly CM10 or the image sensor 200 in a specific direction, or may compensate a negative effect due to the movement by controlling (adjusting a read-out timing and the like) the movement characteristics of the image sensor 200. The image stabilizer CM40 may detect a movement of the camera module CM80 or the electronic apparatus ED01 by using a gyro sensor or an acceleration sensor arranged inside or outside the camera module CM80. The image stabilizer CM40 may be implemented in an optical form.

The memory CM50 may store a part or entire data of an image obtained through the image sensor 200 for subsequent image processing operation. For example, when a plurality of images are obtained at high speed, only low resolution images are displayed while the obtained original data (Bayer-Patterned data, high-resolution data, and the like) is stored in the memory CM50. Then, the original data of a selected (user selection and the like) image may be transmitted to the image signal processor CM60. The memory CM50 may be incorporated into the memory ED30 of the electronic apparatus ED01, or configured to be an independently operated separate memory.

The image signal processor CM60 may perform one or more image processing on the image obtained through the image sensor 200 or the image data stored in the memory CM50. The image processing may include depth map generation, three-dimensional modeling, panorama generation, feature point extraction, image synthesis, and/or image compensation (noise reduction, resolution adjustment, brightness adjustment, blurring, sharpening, softening, and the like). The image signal processor CM60 may perform control (exposure time control, or read-out timing control, and the like) on constituent elements (the image sensor 200 and the like) included in the camera module ED80. The image processed by the image signal processor CM60 may be stored again in the memory CM50 for additional processing or provided to external constituent elements (the memory ED30, the display apparatus ED60, the electronic apparatus ED02, the electronic apparatus ED04, the server ED08, and the like) of the camera module ED80. The image signal processor CM60 may be incorporated into the processor ED20, or configured to be a separate processor operated independently of the processor ED20. When the image signal processor CM60 is configured by a separate processor from the processor ED20, the image processed by the image signal processor CM60 may undergo additional image processing by the processor ED20 and then displayed through the display apparatus ED60.

The electronic apparatus ED01 may include a plurality of camera modules ED80 having different attributes or functions. In this case, one of the camera modules ED80 may be a wide angle camera, and another may be a telephoto camera. Similarly, one of the camera modules ED80 may be a front side camera, and another may be a read side camera.

The image sensor 200 according to embodiments may be applied to a mobile phone or smartphone 5100 of FIG. 20A, a tablet or smart tablet 5200 of FIG. 20B, a digital camera or camcorder 5300 of FIG. 20C, a notebook computer 5400 of FIG. 20D, a television or smart television 5500 of FIG. 20E, or like. For example, the smartphone 5100 or the smart tablet 5200 may include a plurality of high-resolution cameras, each having a high-resolution image sensor mounted thereon. Depth information of objects in an image may be extracted by using high-resolution cameras, out-focusing of an image may be adjusted, or objects in an image may be automatically identified.

Furthermore, the image sensor 200 may be applied to a smart refrigerator 5600 of FIG. 21A, a security camera 5700 of FIG. 21B, a robot 5800 of FIG. 21C, a medical camera 5900 of FIG. 21D, and the like. For example, the smart refrigerator 5600 may automatically identify food in a refrigerator by using an image sensor, and may notify a user of the presence of a specific food, the type of food that is input or output, and the like, through a smartphone. The security camera 5700 may provide a super high resolution image and enable recognition of an object or a person in an image even in a dark environment, by using a high sensitivity. The robot 5800 may be put into disasters or industrial sites that are inaccessible directly by humans and may provide high resolution images. The medical camera 5900 may provide high resolution images for diagnosis or operations, and may dynamically adjust a field of view.

Furthermore, the image sensor 200 may be applied to a vehicle 6000 as illustrated in FIG. 21E. The vehicle 6000 may include cameras 6010, 6020, 6030, and 6040 for a plurality of vehicles, the cameras 6010, 6020, 6030, and 6040 being arranged at various positions. The cameras 6010, 6020, 6030, and 6040 for vehicles may include the image sensor according to an example embodiment. The vehicle 6000 may provide a driver with various pieces of information about the inside or surrounding of the vehicle 6000 by using the cameras 6010, 6020, 6030, and 6040 for vehicles, and may provide information necessary for autonomous driving by automatically recognizing an object or a person in an image.

The color filter according to an example embodiment may reduce the thickness of the color filter by using a plasmonic resonance mode as a plurality of organic layers are coupled to a metal element to have a lateral contact therewith. The image sensor including a color filter according to an example embodiment may be appropriately applied to a miniaturized pixel. The color filter according to an example embodiment may be employed in various electronic apparatuses.

Although the color filter according to an example embodiment, the image sensor, and the electronic apparatus including the same are described based on the embodiments illustrated in the drawings, this is an example, and one of skilled in the art would understand that various modifications are possible within the scope of the appended claims.

It should be understood that embodiments described herein should be considered in a descriptive sense only and not for purposes of limitation. Descriptions of features or aspects within each embodiment should typically be considered as available for other similar features or aspects in other embodiments.

## Claims

**1.** A color filter (100) comprising:

a first dielectric layer (110);
a second dielectric layer (120) on the first dielectric layer (110); and
a metal array (130) formed on the first dielectric layer (110) and the second dielectric layer (120), the metal array (130) comprising a plurality of metal elements (131) buried in both of the first dielectric layer (110) and the second dielectric layer (120),
wherein each of the plurality of metal elements (131) are in lateral contact with each of the first dielectric layer (110) and the second dielectric layer (120),
wherein each of the plurality of metal elements (131) are spaced apart from each other, and
**characterised in that**
a first refractive index of the first dielectric layer (110) is different from a second refractive index of the second dielectric layer (120).

**2.** The color filter (100) of claim 1, wherein a first ratio (d1/d) of a first thickness d1 of the first dielectric layer (110) in lateral contact with each of the plurality of metal elements (131) to a thickness d of the metal element (131) is in a range of 0.1 to 0.9, and
a second ratio (d2/d) of a second thickness d2 of the second dielectric layer (131) in lateral contact with each of the plurality of metal elements (131) to the thickness d of the metal element (131) is in a range of 0.1 to 0.9.

**3.** The color filter (100) of any preceding claim, wherein, in a first plasmonic resonance mode occurring between the first dielectric layer (110) and each of the plurality of metal elements (131), a central wavelength of a transmission wavelength band of light is tuned to a wavelength of one of blue color, green color, or red color, and/or
wherein, in a second plasmonic resonance mode occurring between the second dielectric layer (120) and each of the plurality of metal elements (131), transmitted light has a full width at half maximum of 50 nm or more.

**4.** The color filter (100) of any preceding claim, wherein a sum of thicknesses of the first dielectric layer (110) and the second dielectric layer (120) is in a range of 400 nm or less, and/or
wherein an arrangement period of the plurality of metal elements (131) is in a range of 400 nm or less.

**5.** The color filter (100) of any preceding claim, further comprising a third dielectric layer,
wherein each of the plurality of metal elements is arranged in lateral contact with the third dielectric layer (125).

**6.** The color filter (100) of any preceding claim, wherein a plurality of pairs of the first dielectric layer (110) and the second dielectric layer (120) are alternatingly stacked forming a distributed Bragg reflective layer.

**7.** The color filter (100) of any preceding claim, wherein the first dielectric layer includes one of SiO2, SiN, TiO2, $Al_2O_3$, and HfO2, and/or

wherein the second dielectric layer (120) comprises one of SiO2, SiN, TiO2, Al2O3, or HfO2.

**8.** The color filter (100) of any preceding claim, wherein each of the plurality of metal elements (131) comprises at least one of Al, Au, Ag, W, Ti, Ni, or Cr.

**9.** The color filter (100) of any preceding claim, wherein each of the plurality of metal elements (131) has one of a circular cross-section, a rectangular cross-section, a polygonal cross-section, an oval cross-section, a cross-shaped cross-section, or a ring-shaped cross-section.

**10.** The color filter (100) of any preceding claim, wherein a transmission wavelength bandwidth of incident light is adjusted by adjusting at least one of thicknesses of each of the plurality of metal elements (131) in lateral contact with the first dielectric layer (110) and the second dielectric layer (120), an arrangement period of the plurality of metal elements (131), a maximum diameter of a cross-section of each of the plurality of metal elements (131), and a lateral surface inclination angle of each of the plurality of metal elements (131).

**11.** An image sensor (200) comprising:

a photodetector (210) comprising a plurality of photodetector cells (211, 212,3 213, 214) for detecting light; and
a color filter (100) according to any preceding claim provided on the photodetector (210).

**12.** The image sensor (200) of claim 11, wherein the photodetector (210) comprises a silicon-based photodiode.

**13.** The image sensor (200) of claim 11 or 12, further comprising a micro-lens array (230) for focusing light on the color filter.

**14.** An electronic apparatus (ED01) comprising the image sensor (200) according to any of claims 11 to 13,
in particular, comprising a mobile phone, a smartphone, a tablet computer, a smart tablet, a digital camera, a camcorder, a notebook computer, a television, a smart television, a smart refrigerator, a security camera, a robot, or a medical camera.

## Patentansprüche

**1.** Farbfilter (100), umfassend:

eine erste dielektrische Schicht (110);
eine zweite dielektrische Schicht (120) auf der ersten dielektrischen Schicht (110); und
eine Metallanordnung (130), die auf der ersten dielektrischen Schicht (110) und der zweiten dielektrischen Schicht (120) ausgebildet ist, wobei die Metallanordnung (130) eine Vielzahl von Metallelementen (131) umfasst, die sowohl in der ersten dielektrischen Schicht (110) als auch in der zweiten dielektrischen Schicht (120) vergraben sind,
wobei jedes der Vielzahl von Metallelementen (131) in lateralem Kontakt mit jeder der ersten dielektrischen Schicht (110) und der zweiten dielektrischen Schicht (120) steht,
wobei jedes der Vielzahl von Metallelementen (131) voneinander beabstandet ist, und
**dadurch gekennzeichnet, dass**
ein erster Brechungsindex der ersten dielektrischen Schicht (110) von einem zweiten Brechungsindex der zweiten dielektrischen Schicht (120) verschieden ist.

**2.** Farbfilter (100) nach Anspruch 1, wobei ein erstes Verhältnis (d1/d) einer ersten Dicke d1 der ersten dielektrischen Schicht (110) in lateralem Kontakt mit jedem der Vielzahl von Metallelementen (131) zu einer Dicke d des Metallelements (131) in einem Bereich von 0,1 bis 0,9 liegt, und
ein zweites Verhältnis (d2/d) einer zweiten Dicke d2 der zweiten dielektrischen Schicht (131) in lateralem Kontakt mit jedem der Vielzahl von Metallelementen (131) zu der Dicke d des Metallelements (131) in einem Bereich von 0,1 bis 0,9 liegt.

**3.** Farbfilter (100) nach einem der vorhergehenden Ansprüche, wobei in einem ersten plasmonischen Resonanzmodus, der zwischen der ersten dielektrischen Schicht (110) und jedem der Vielzahl von Metallelementen (131) auftritt, eine zentrale Wellenlänge eines Transmissionswellenlängenbandes des Lichts auf eine Wellenlänge von einer von blauer Farbe, grüner Farbe oder roter Farbe abgestimmt ist, und/oder
wobei in einem zweiten plasmonischen Resonanzmodus, der zwischen der zweiten dielektrischen Schicht (120) und jedem der Vielzahl von Metallelementen (131) auftritt, das übertragene Licht eine Halbwertsbreite von 50 nm oder mehr aufweist.

**4.** Farbfilter (100) nach einem der vorhergehenden Ansprüche, wobei eine Summe aus der Dicke der ersten dielektrischen Schicht (110) und der zweiten dielektrischen Schicht (120) in einem Bereich von 400 nm oder weniger liegt, und/oder
wobei eine Anordnungsperiode der Vielzahl von Metallelementen (131) in einem Bereich von 400 nm oder weniger liegt.

**5.** Farbfilter (100) nach einem der vorhergehenden Ansprüche, des Weiteren umfassend eine dritte dielektrische Schicht, wobei jedes der Vielzahl von Metallelementen in lateralem Kontakt mit der dritten dielektrischen Schicht (125) angeordnet ist.

**6.** Farbfilter (100) nach einem der vorhergehenden Ansprüche, wobei eine Vielzahl von Paaren der ersten dielektrischen Schicht (110) und der zweiten dielektrischen Schicht (120) abwechselnd gestapelt sind und eine verteilte Bragg-Reflexionsschicht bilden.

**7.** Farbfilter (100) nach einem der vorhergehenden Ansprüche, wobei die erste dielektrische Schicht eines von SiO2, SiN, $TiO_2$, Al2O3 und HfO2 beinhaltet, und/oder
wobei die zweite dielektrische Schicht (120) eines von SiO2, SiN, TiO2, Al2O3 oder HfO2 umfasst.

**8.** Farbfilter (100) nach einem der vorhergehenden Ansprüche, wobei jedes der Vielzahl von Metallelementen (131) mindestens eines von Al, Au, Ag, W, Ti, Ni oder Cr umfasst.

**9.** Farbfilter (100) nach einem der vorhergehenden Ansprüche, wobei jedes der Vielzahl von Metallelementen (131) einen aus einem kreisförmigen Querschnitt, einem rechteckigen Querschnitt, einem polygonalen Querschnitt, einem ovalen Querschnitt, einem kreuzförmigen Querschnitt oder einem ringförmigen Querschnitt aufweist.

**10.** Farbfilter (100) nach einem der vorhergehenden Ansprüche, wobei eine Transmissionswellenlängenbandbreite des einfallenden Lichts durch Einstellen mindestens einer der Dicken jedes der Vielzahl von Metallelementen (131) in lateralem Kontakt mit der ersten dielektrischen Schicht (110) und der zweiten dielektrischen Schicht (120), einer Anordnungsperiode der Vielzahl von Metallelementen (131), eines maximalen Durchmessers eines Querschnitts jedes der Vielzahl von Metallelementen (131) und eines lateralen Oberflächenneigungswinkels jedes der Vielzahl von Metallelementen (131) eingestellt wird.

**11.** Bildsensor (200), umfassend:

einen Fotodetektor (210), der eine Vielzahl von Fotodetektorzellen (211, 212, 213, 214) zum Erkennen von Licht umfasst; und
einen Farbfilter (100) nach einem der vorhergehenden Ansprüche, der auf dem Fotodetektor (210) vorgesehen ist.

**12.** Bildsensor (200) nach Anspruch 11, wobei der Fotodetektor (210) eine Fotodiode auf Siliziumbasis umfasst.

**13.** Bildsensor (200) nach Anspruch 11 oder 12, des Weiteren umfassend eine Mikrolinsenanordnung (230) zum Fokussieren von Licht auf den Farbfilter.

**14.** Elektronisches Gerät (ED01), umfassend den Bildsensor (200) nach einem der Ansprüche 11 bis 13,
insbesondere umfassend ein Mobiltelefon, ein Smartphone, einen Tablet-Computer, ein Smart-Tablet, eine Digitalkamera, einen Camcorder, ein Notebook, einen Fernseher, einen Smart-TV, einen Smart-Kühlschrank, eine Überwachungskamera, einen Roboter oder eine medizinische Kamera.

## Revendications

**1.** Filtre coloré (100) comprenant :

une première couche diélectrique (110) ;
une deuxième couche diélectrique (120) sur la première couche diélectrique (110) ; et
un réseau métallique (130) formé sur la première couche diélectrique (110) et la deuxième couche diélectrique (120), le réseau métallique (130) comprenant une pluralité d'éléments métalliques (131) enfouis à la fois dans la première couche diélectrique (110) et la deuxième couche diélectrique (120),
dans lequel chacun de la pluralité d'éléments métalliques (131) est en contact latéral avec chacune de la première couche diélectrique (110) et de la deuxième couche diélectrique (120),
dans lequel chacun de la pluralité d'éléments métalliques (131) est espacé des autres, et
**caractérisé en ce qu'**un premier indice de réfraction de la première couche diélectrique (110) diffère d'un second indice de réfraction de la deuxième couche diélectrique (120).

2. Filtre coloré (100) selon la revendication 1, dans lequel un premier rapport (d1/d) entre une première épaisseur d1 de la première couche diélectrique (110) en contact latéral avec chacun de la pluralité d'éléments métalliques (131) et une épaisseur d de l'élément métallique (131) est dans une plage de 0,1 à 0,9, et
un second rapport (d2/d) entre une seconde épaisseur d2 de la deuxième couche diélectrique (131) en contact latéral avec chacun de la pluralité d'éléments métalliques (131) et l'épaisseur d de l'élément métallique (131) est dans une plage de 0,1 à 0,9.

3. Filtre coloré (100) selon une quelconque revendication précédente, dans lequel, dans un premier mode de résonance plasmonique se produisant entre la première couche diélectrique (110) et chacun de la pluralité d'éléments métalliques (131), une longueur d'onde centrale d'une bande de longueur d'onde de transmission d'une lumière est accordée à une longueur d'onde de l'une d'une couleur bleue, d'une couleur verte ou d'une couleur rouge, et/ou dans lequel, dans un second mode de résonance plasmonique se produisant entre la deuxième couche diélectrique (120) et chacun de la pluralité d'éléments métalliques (131), une lumière transmise a une largeur maximale à mi-hauteur de 50 nm ou plus.

4. Filtre coloré (100) selon une quelconque revendication précédente, dans lequel une somme d'épaisseurs de la première couche diélectrique (110) et de la deuxième couche diélectrique (120) se trouve dans une plage de 400 nm ou moins, et/ou
dans lequel une période d'arrangement de la pluralité d'éléments métalliques (131) se trouve dans une plage de 400 nm ou moins.

5. Filtre coloré (100) selon une quelconque revendication précédente, comprenant en outre une troisième couche diélectrique, dans lequel chacun de la pluralité d'éléments métalliques est arrangé en contact latéral avec la troisième couche diélectrique (125).

6. Filtre coloré (100) selon une quelconque revendication précédente, dans lequel une pluralité de paires de la première couche diélectrique (110) et de la deuxième couche diélectrique (120) sont empilées alternativement en formant une couche à réflexion de Bragg distribuée.

7. Filtre coloré (100) selon une quelconque revendication précédente, dans lequel la première couche diélectrique comporte l'un parmi SiO2, SiN, $TiO_2$, Al2O3 et HfO2, et/ou
dans lequel la deuxième couche diélectrique (120) comprend l'un parmi SiO2, SiN, TiO2, Al2O3 ou HfO2.

8. Filtre coloré (100) selon une quelconque revendication précédente, dans lequel chacun de la pluralité d'éléments métalliques (131) comprend au moins l'un parmi Al, Au, Ag, W, Ti, Ni ou Cr.

9. Filtre coloré (100) selon une quelconque revendication précédente, dans lequel chacun de la pluralité d'éléments métalliques (131) présente l'une parmi une coupe transversale circulaire, une coupe transversale rectangulaire, une coupe transversale polygonale, une coupe transversale ovale, une coupe transversale en forme de croix ou une coupe transversale en forme d'anneau.

10. Filtre coloré (100) selon une quelconque revendication précédente, dans lequel une largeur de bande de longueur d'onde de transmission d'une lumière incidente est ajustée en ajustant au moins l'un parmi des épaisseurs de chacun de la pluralité d'éléments métalliques (131) en contact latéral avec la première couche diélectrique (110) et la deuxième couche diélectrique (120), une période d'arrangement de la pluralité d'éléments métalliques (131), un diamètre maximal d'une coupe transversale de chacun de la pluralité d'éléments métalliques (131), et un angle d'inclinaison de surface latérale de chacun de la pluralité d'éléments métalliques (131).

**11.** Capteur d’image (200) comprenant :

un photodétecteur (210) comprenant une pluralité de cellules photodétectrices (211, 212, 3 213, 214) pour détecter de la lumière ; et
un filtre coloré (100) selon une quelconque revendication précédente disposé sur le photodétecteur (210).

**12.** Capteur d’image (200) selon la revendication 11, dans lequel le photodétecteur (210) comprend une photodiode à base de silicium.

**13.** Capteur d’image (200) selon la revendication 11 ou 12, comprenant en outre un réseau de microlentilles (230) pour focaliser de la lumière sur le filtre coloré.

**14.** Appareil électronique (ED01) comprenant le capteur d’image (200) selon l’une quelconque des revendications 11 à 13,
en particulier, comprenant un téléphone portable, un smartphone, une tablette, une tablette intelligente, un appareil photo numérique, un caméscope, un ordinateur portable, une télévision, une télévision intelligente, un réfrigérateur intelligent, une caméra de sécurité, un robot ou une caméra médicale.

FIG. 1

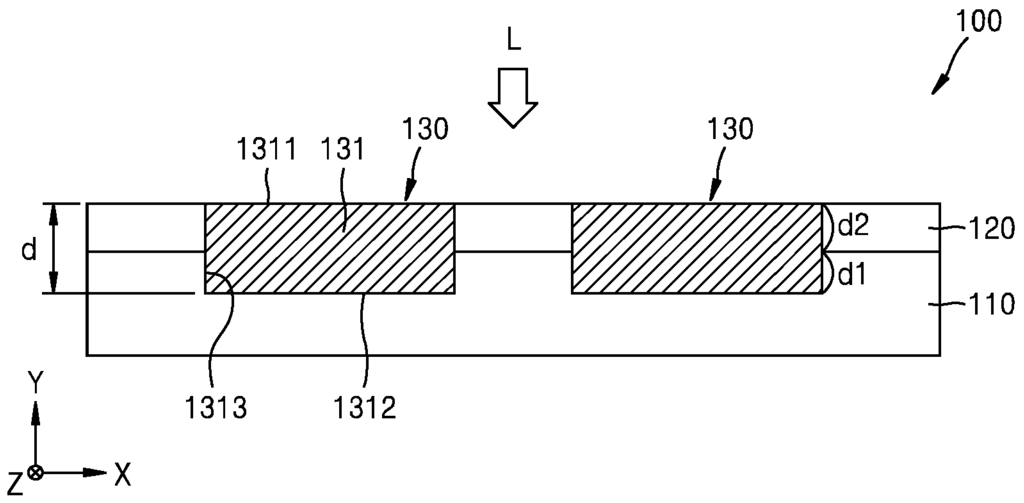

FIG. 2

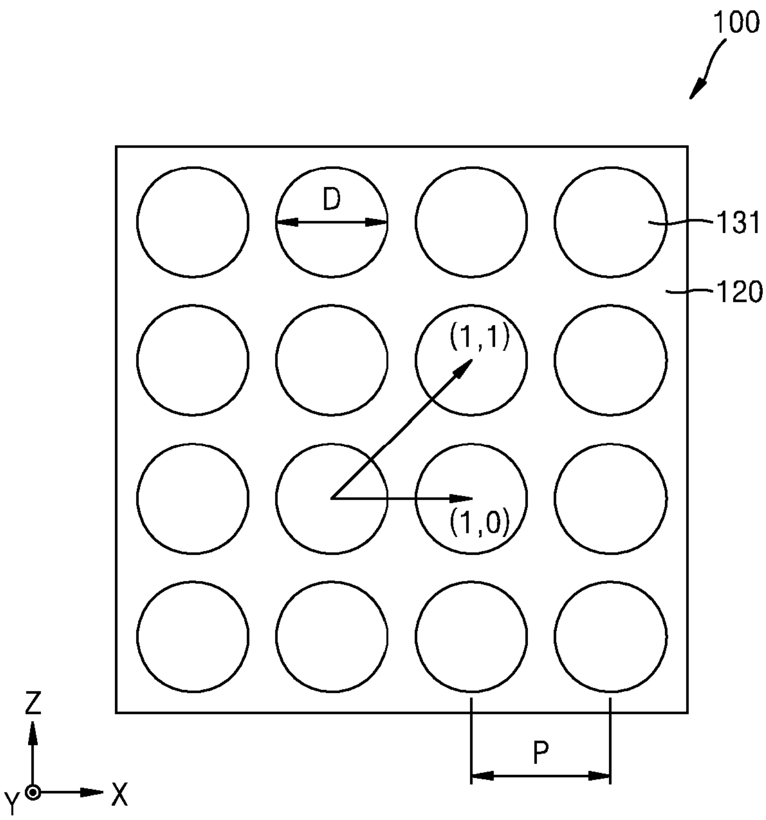

FIG. 3

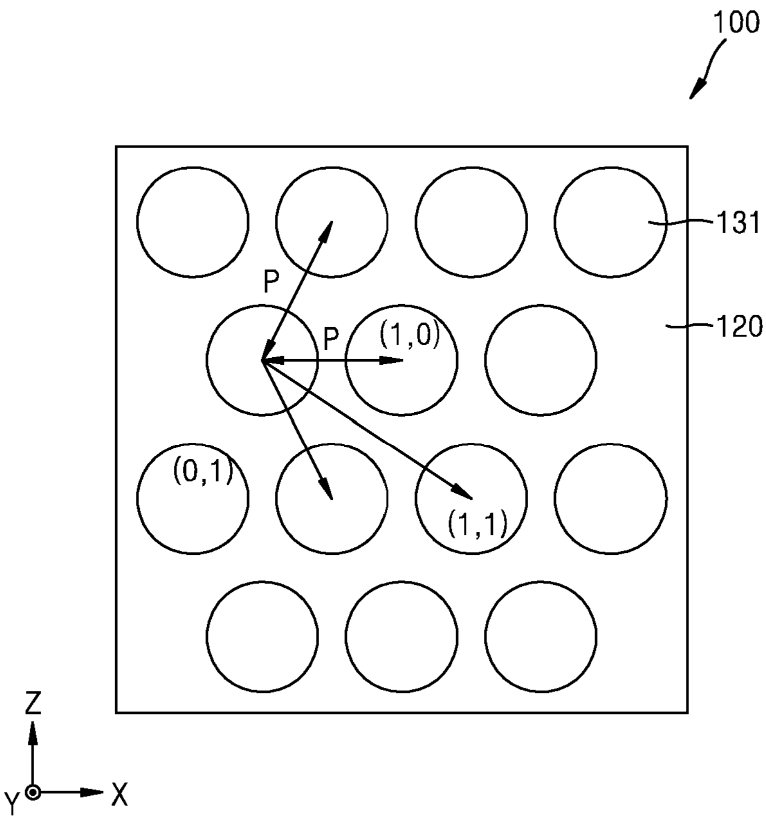

FIG. 4

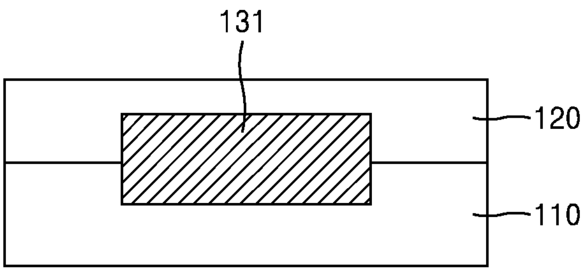

FIG. 5A

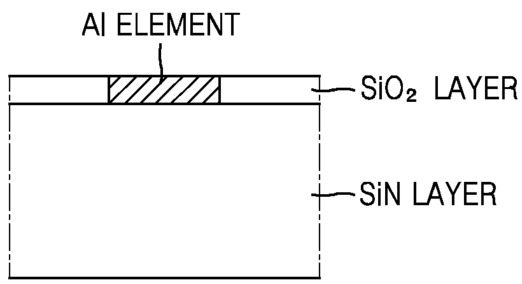

FIG. 5B

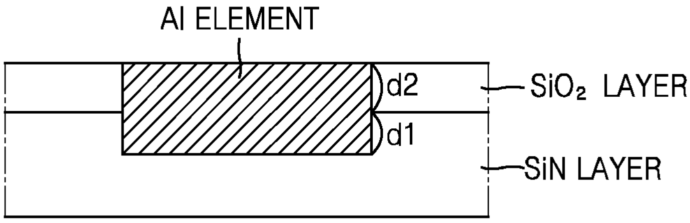

FIG. 5C

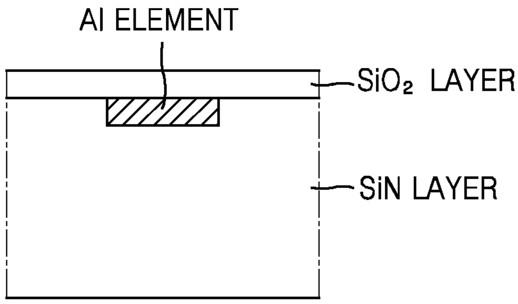

FIG. 6

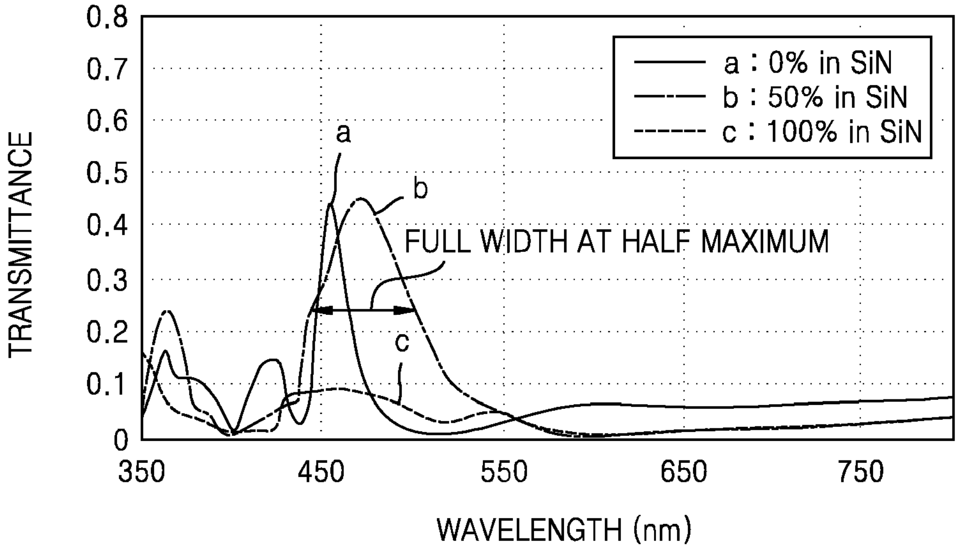
0.8
0.7
0.6
0.5
0.4
0.3
0.2
0.1
0
350
450
550
650
750
TRANSMITTANCE
WAVELENGTH (nm)
a : 0% in SiN
b : 50% in SiN
c : 100% in SiN
a
b
c
FULL WIDTH AT HALF MAXIMUM

FIG. 7

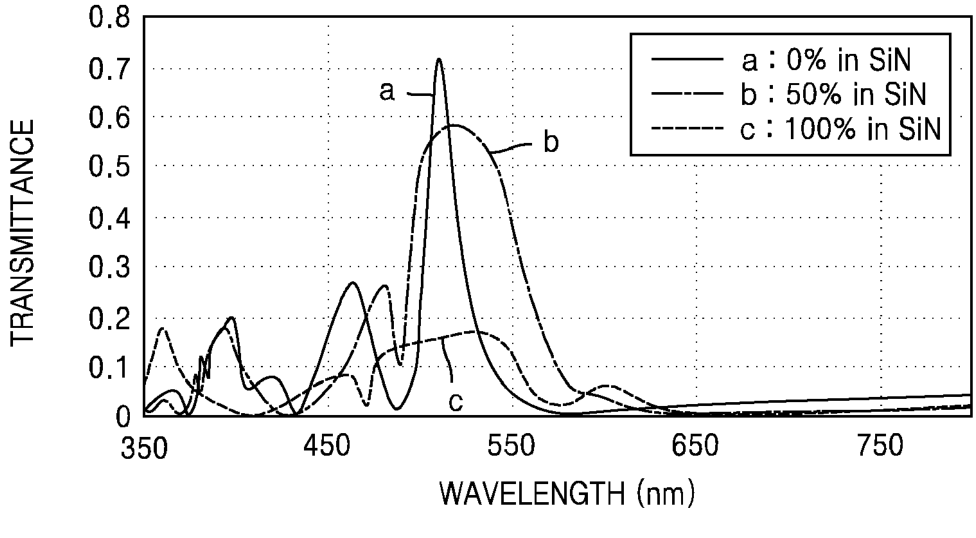
0.8
0.7
0.6
0.5
0.4
0.3
0.2
0.1
0
TRANSMITTANCE
350
450
550
650
750
WAVELENGTH (nm)
a : 0% in SiN
b : 50% in SiN
c : 100% in SiN
a
b
c

FIG. 8

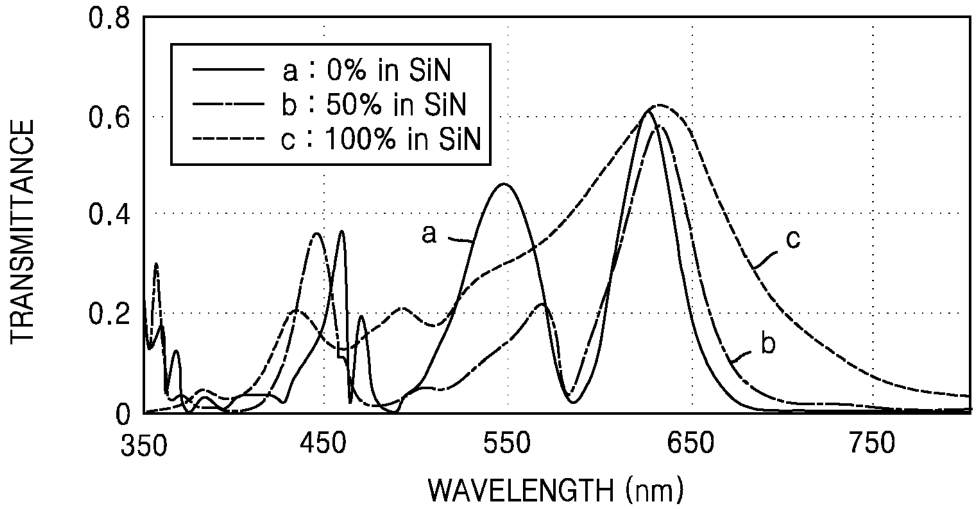
0.8
0.6
0.4
0.2
0
TRANSMITTANCE
a : 0% in SiN
b : 50% in SiN
c : 100% in SiN
a
b
c
350
450
550
650
750
WAVELENGTH (nm)

FIG. 9A

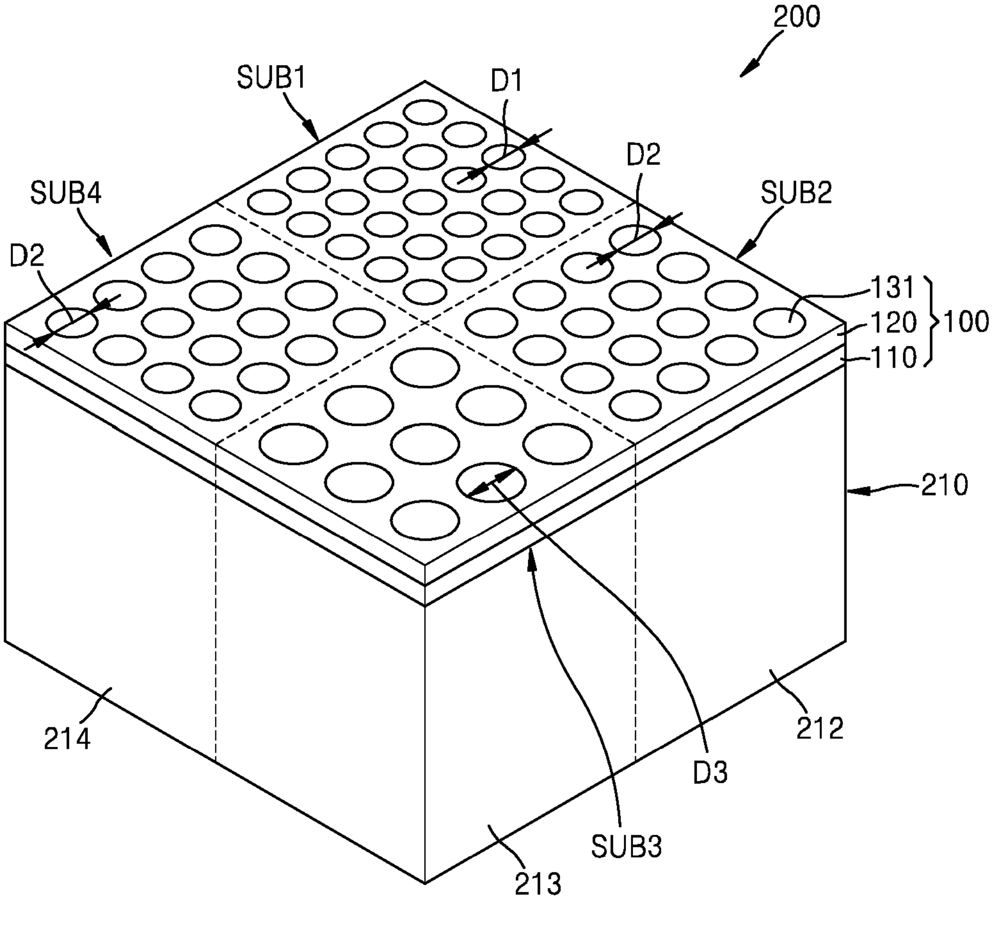
200
SUB1
D1
D2
SUB4
SUB2
D2
131
120
100
110
210
214
212
D3
SUB3
213

FIG. 9B

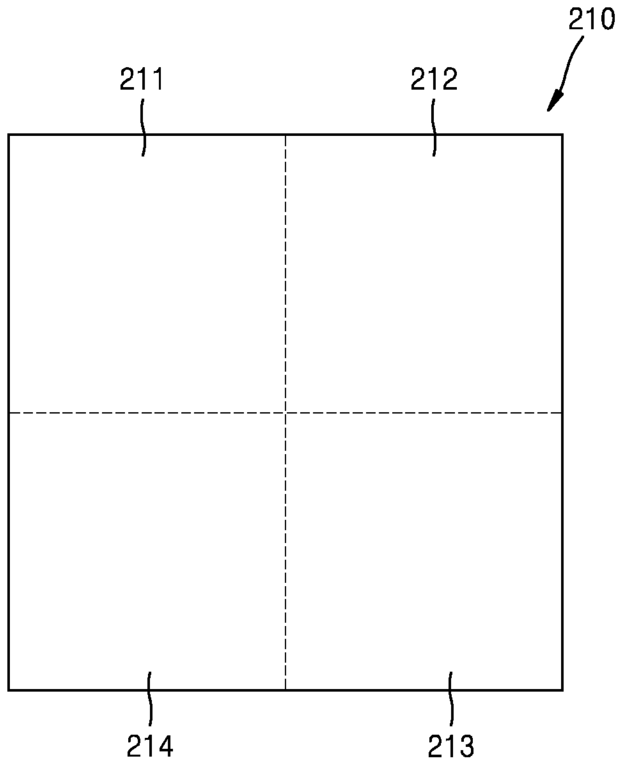

FIG. 10

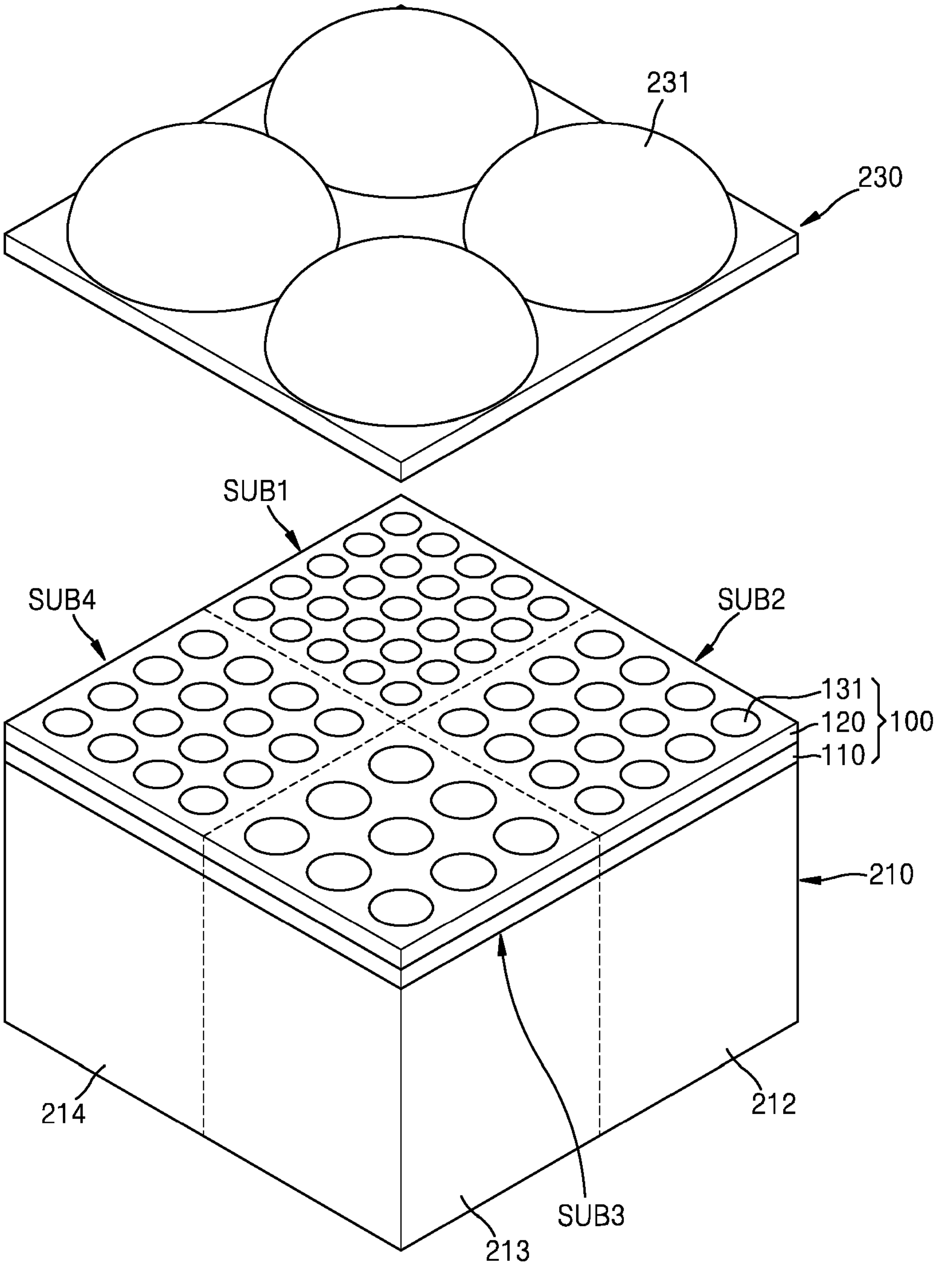

FIG. 11

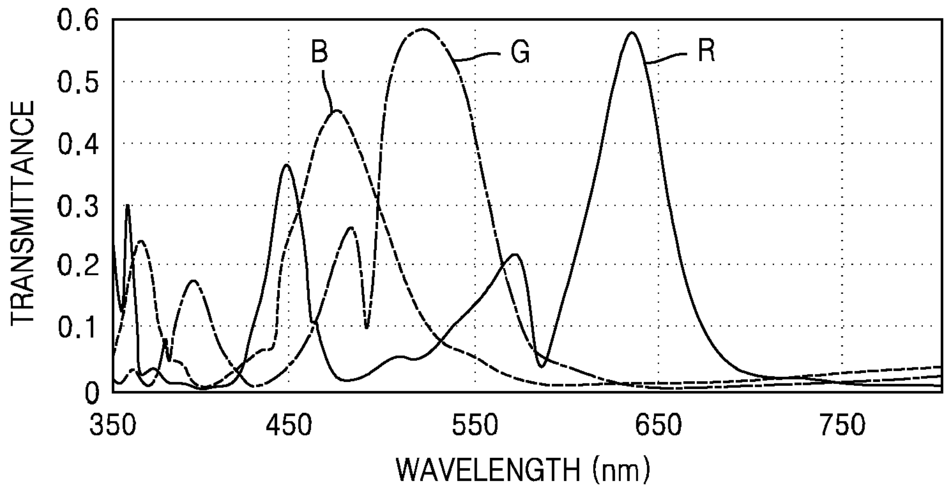
0.6
0.5
0.4
0.3
0.2
0.1
0
TRANSMITTANCE
B
G
R
350
450
550
650
750
WAVELENGTH (nm)

FIG. 12

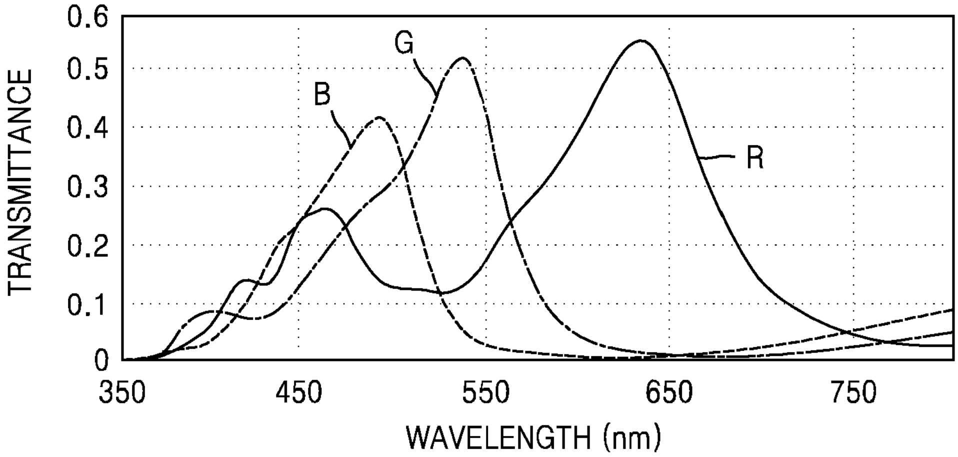

TRANSMITTANCE
0.6
0.5
0.4
0.3
0.2
0.1
0
350
450
550
650
750
WAVELENGTH (nm)
B
G
R

FIG. 13

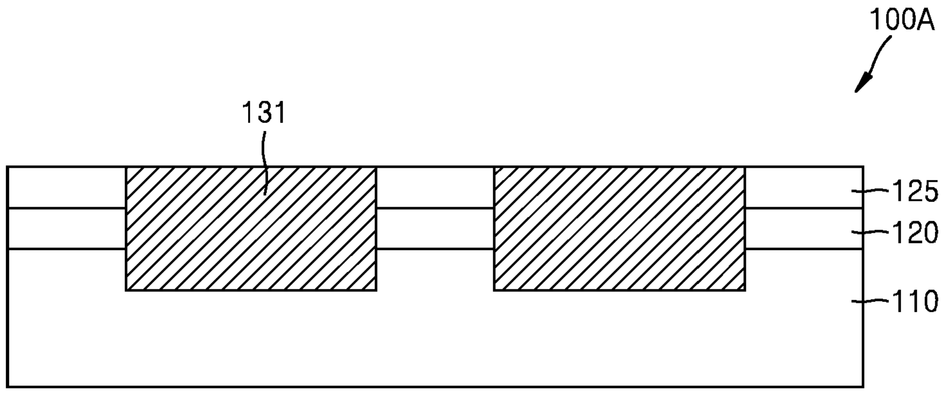

FIG. 14

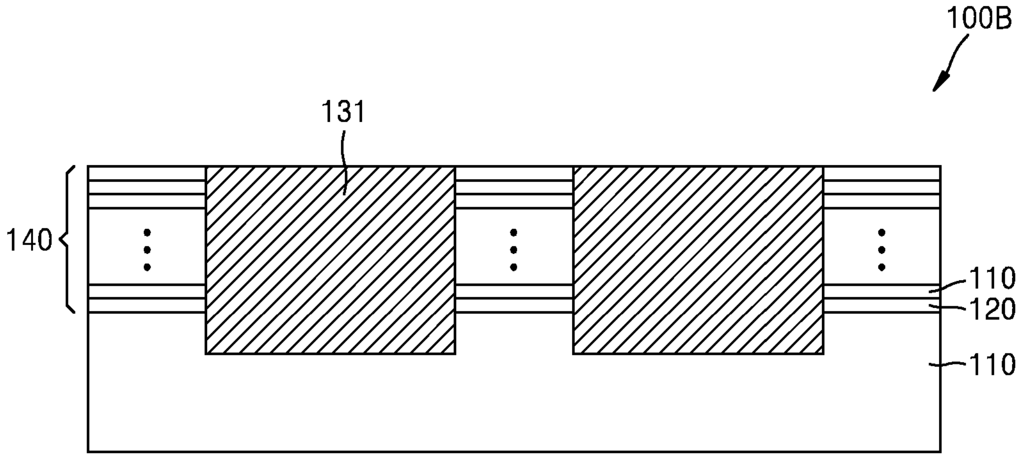

FIG. 15A

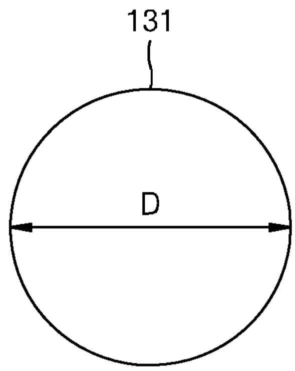

FIG. 15B

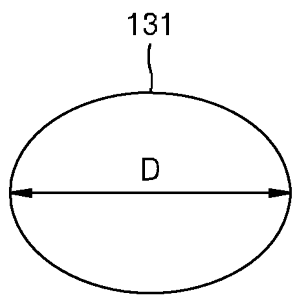

FIG. 15C

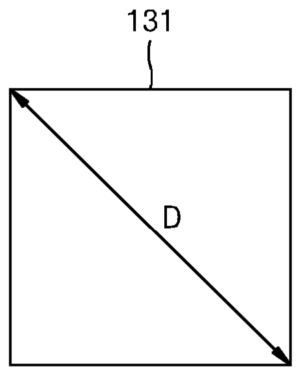

FIG. 15D

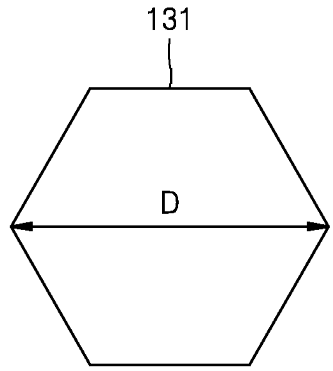

FIG. 15E

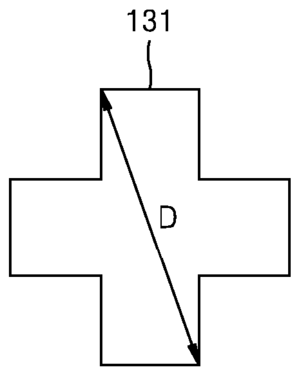

FIG. 15F

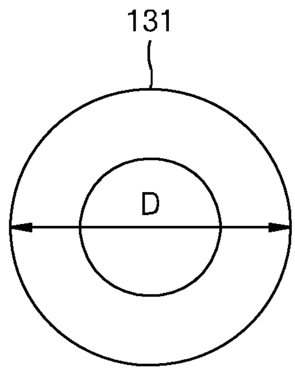

FIG. 16

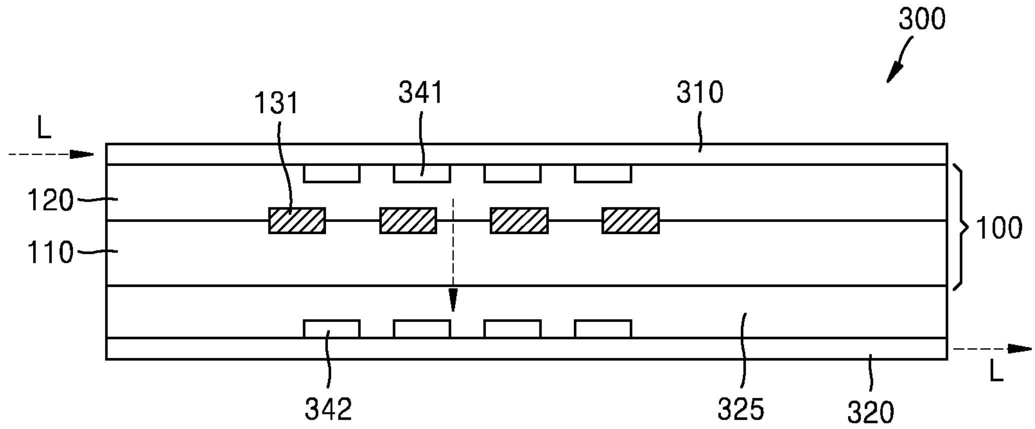

FIG. 17

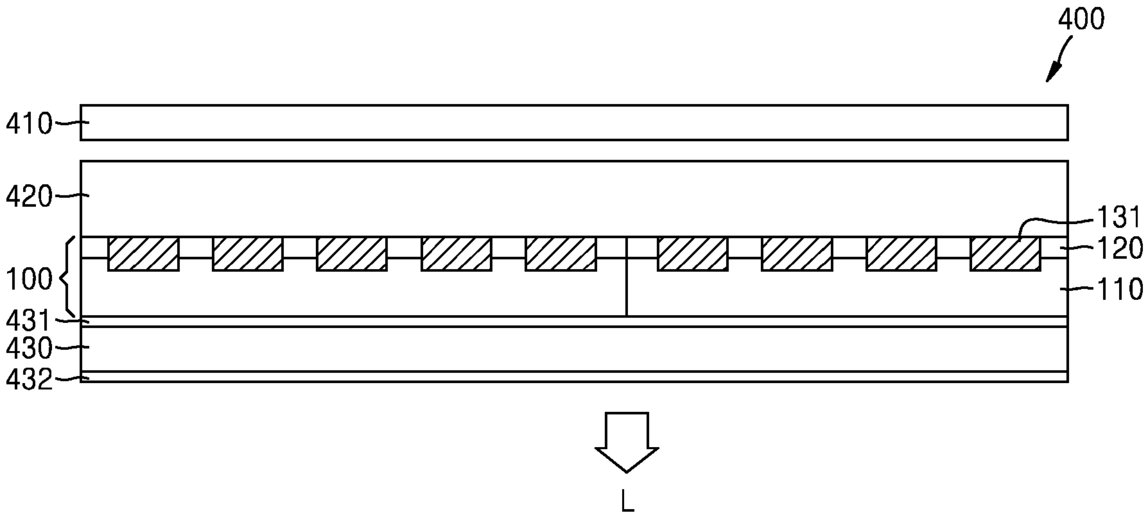

FIG. 18

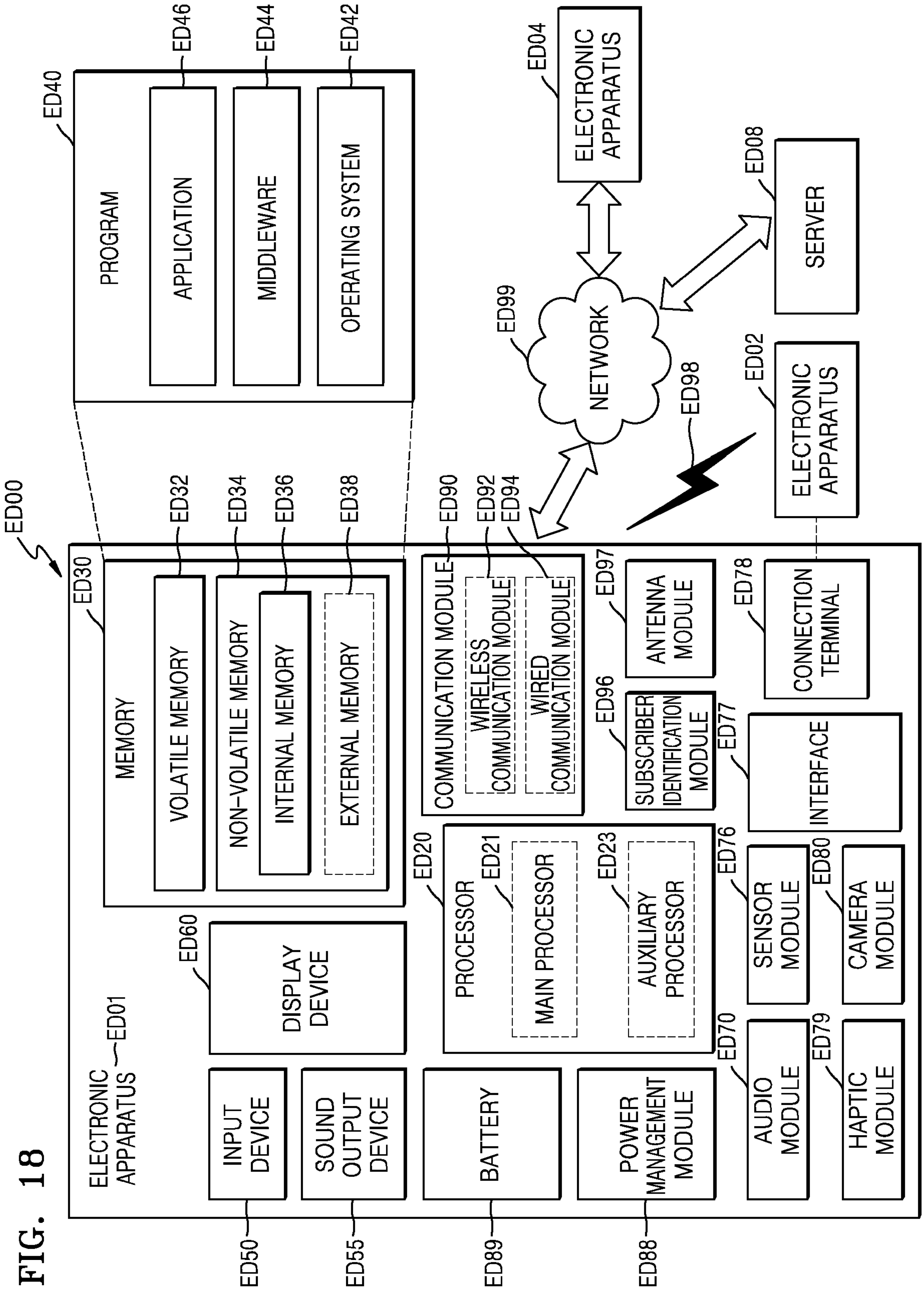
ED00
ELECTRONIC APPARATUS
ED01
ED30
MEMORY
ED32
VOLATILE MEMORY
ED34
NON-VOLATILE MEMORY
ED36
INTERNAL MEMORY
ED38
EXTERNAL MEMORY
ED40
PROGRAM
ED46
APPLICATION
ED44
MIDDLEWARE
ED42
OPERATING SYSTEM
ED50
INPUT DEVICE
ED55
SOUND OUTPUT DEVICE
ED60
DISPLAY DEVICE
ED89
BATTERY
ED88
POWER MANAGEMENT MODULE
ED20
PROCESSOR
ED21
MAIN PROCESSOR
ED23
AUXILIARY PROCESSOR
ED90
COMMUNICATION MODULE
ED92
WIRELESS COMMUNICATION MODULE
ED94
WIRED COMMUNICATION MODULE
ED97
ANTENNA MODULE
ED96
SUBSCRIBER IDENTIFICATION MODULE
ED78
CONNECTION TERMINAL
ED77
INTERFACE
ED76
SENSOR MODULE
ED80
CAMERA MODULE
ED70
AUDIO MODULE
ED79
HAPTIC MODULE
ED99
NETWORK
ED98
ED04
ELECTRONIC APPARATUS
ED08
SERVER
ED02
ELECTRONIC APPARATUS

FIG. 19

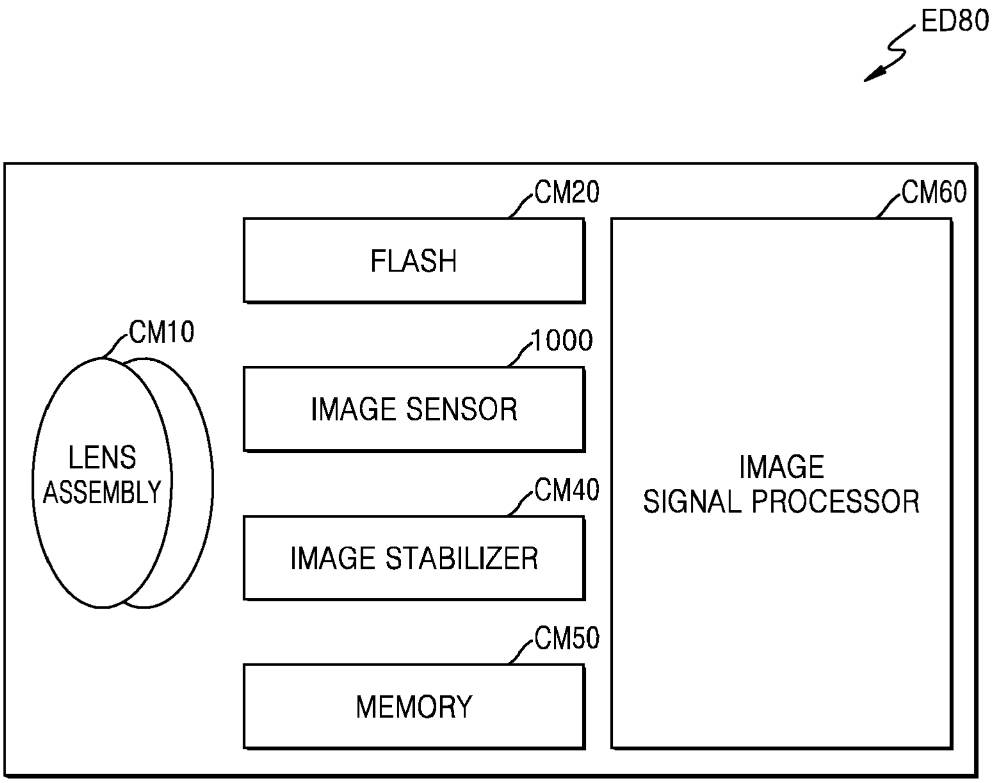
ED80
CM20
CM60
FLASH
CM10
1000
IMAGE SENSOR
LENS ASSEMBLY
IMAGE SIGNAL PROCESSOR
CM40
IMAGE STABILIZER
CM50
MEMORY

FIG. 20A

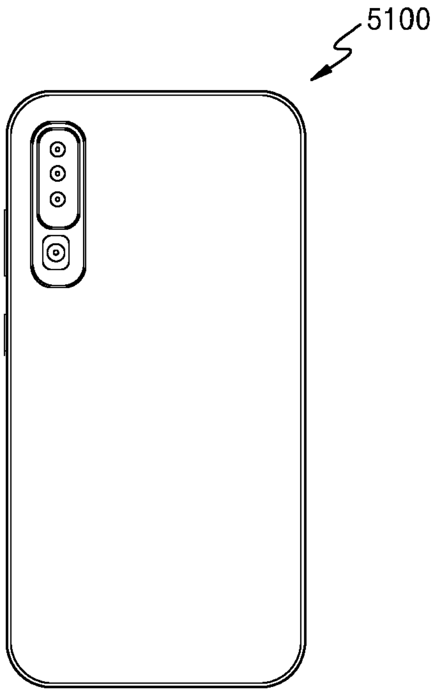

FIG. 20B

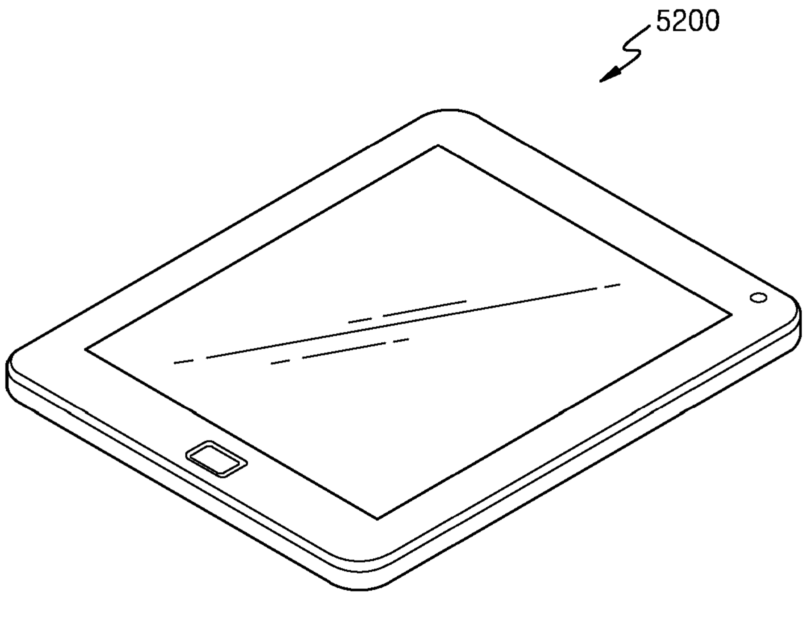

FIG. 20C

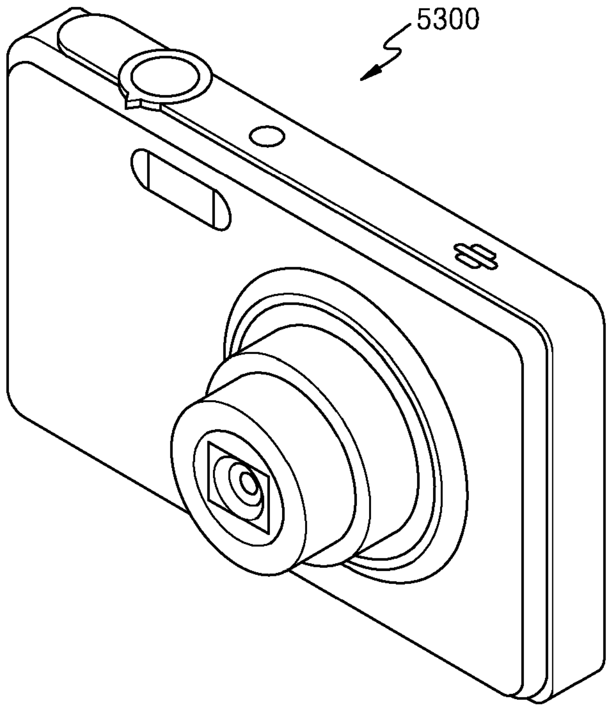

FIG. 20D

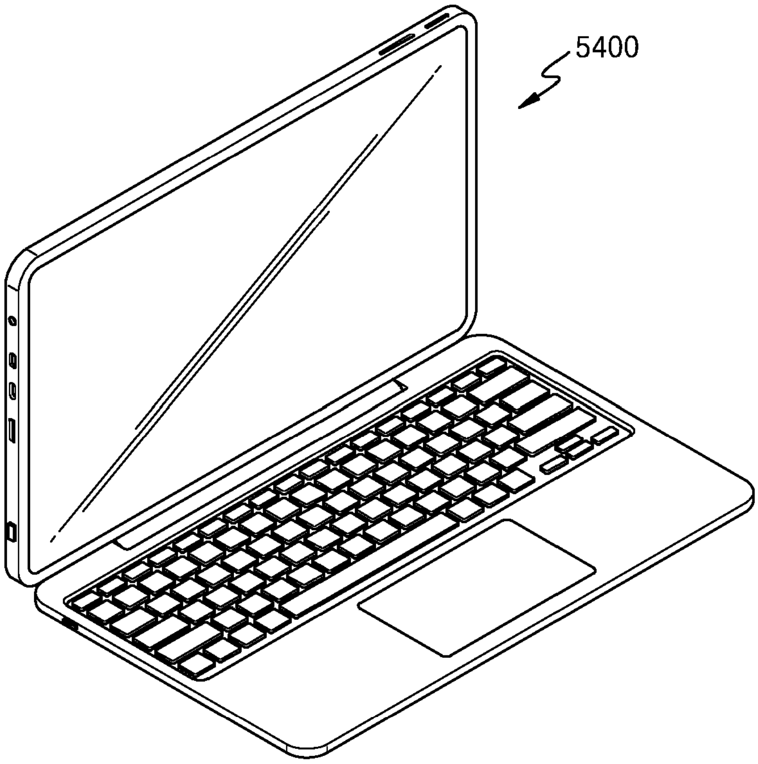

FIG. 20E

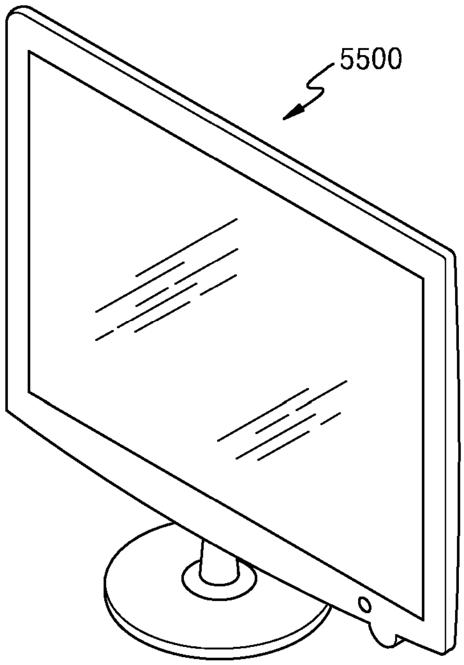

FIG. 21A

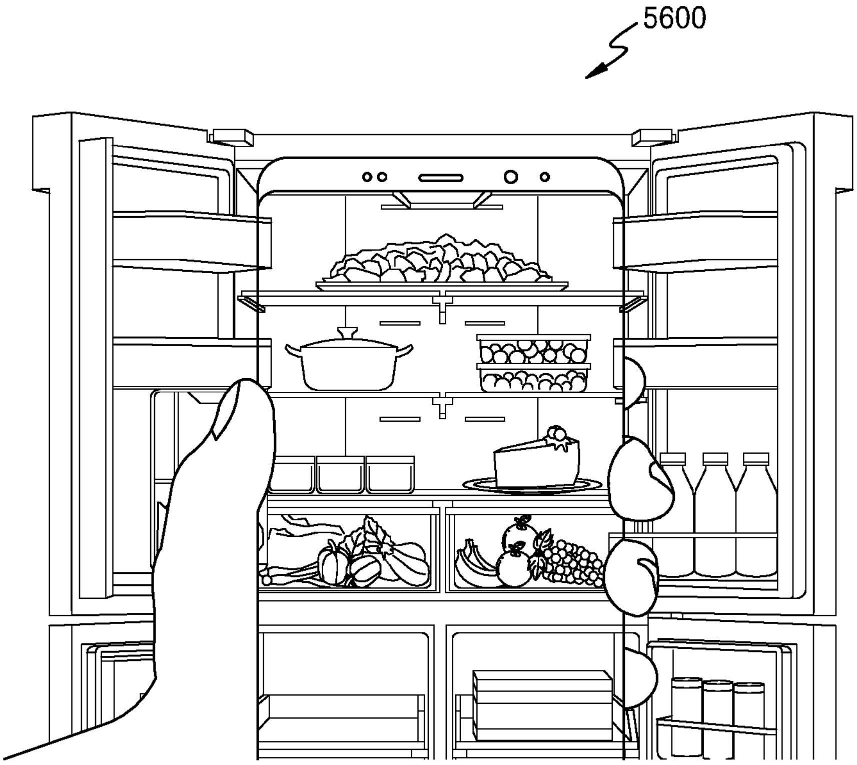

FIG. 21B

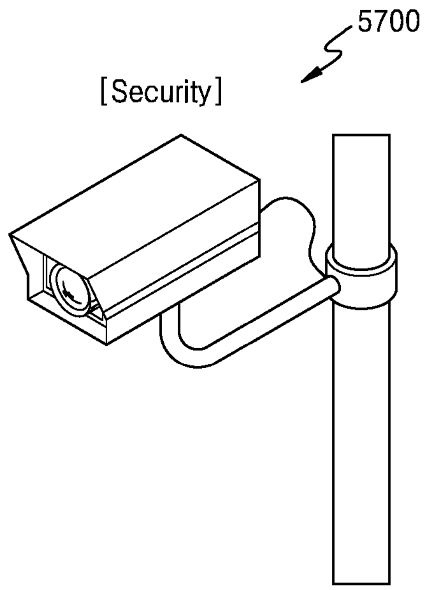

FIG. 21C

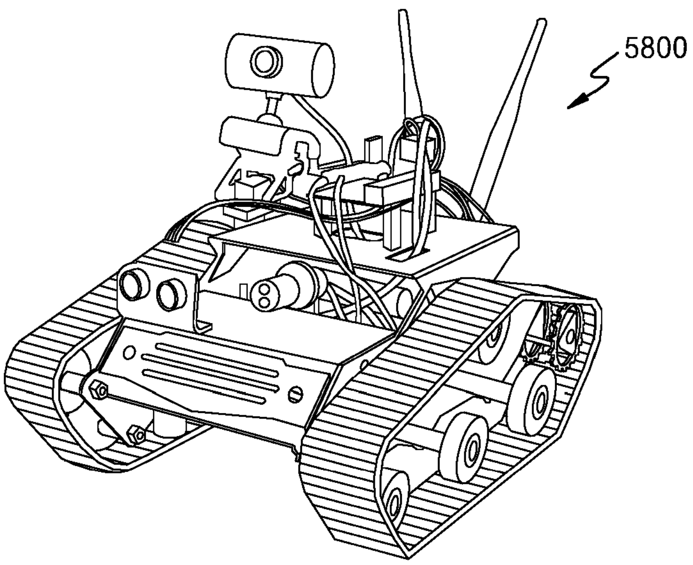

FIG. 21D

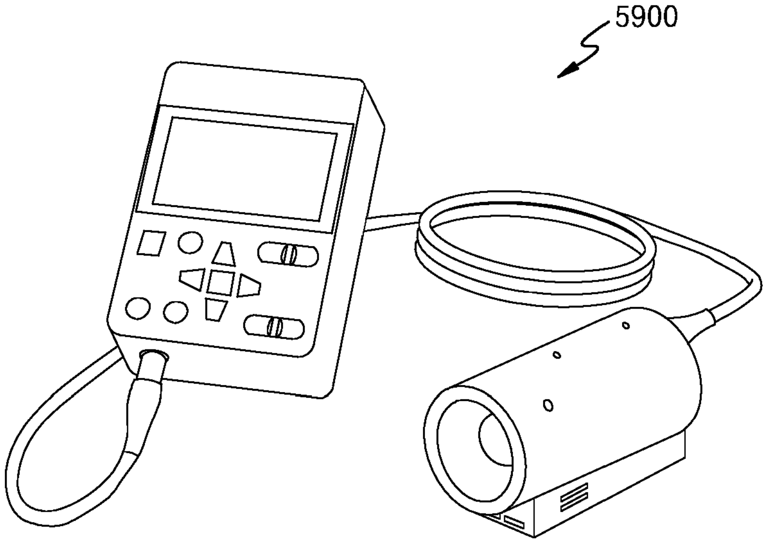

FIG. 21E

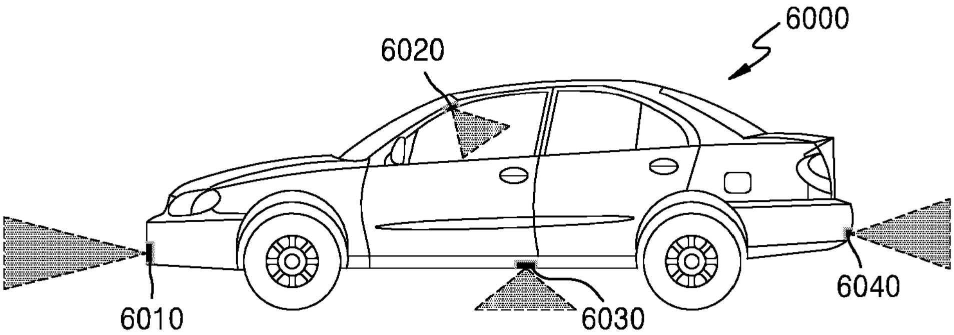

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **DE PROFT et al.** Highly Selective Color Filters Based on Hybrid Plasmonic-Dielectric Nanostructures. *ACS Photonics*, 2022, vol. 9 (4), 1349-1357
- **CATRYSSE et al.** Integrated color pixels in a 0.18-μm complementary metal oxide semiconductor technology. *Journal of the Optical Society of America A*, 2003, vol. 20 (12), 2293-2306